# EUROPEAN PATENT APPLICATION

(11) **EP 4 044 783 A1**
(43) Date of publication of application: **17.08.2022**
(21) Application number: 20892950.5
(22) Date of filing: 10.11.2020
(51) Int. Cl.: H05K 9/00

(54) **SHIELDING APPARATUS AND ELECTRONIC DEVICE**

(30) Priority: 29.11.2019 CN 201911203745
(71) Applicant: Huawei Technologies Co., Ltd., Longgang Shenzhen, Guangdong 518129 (CN)
(72) Inventor: KONG, Bo, Shenzhen, Guangdong 518129 (CN); LIU, Chenjun, Shenzhen, Guangdong 518129 (CN); WANG, Tianpeng, Shenzhen, Guangdong 518129 (CN); DI, Wei, Shenzhen, Guangdong 518129 (CN); ZHOU, Jianjun, Shenzhen, Guangdong 518129 (CN)
(74) Representative: Epping - Hermann - Fischer
(86) International application number: PCT/CN2020/127735
(87) International publication number: WO 2021/104004

(57) **Abstract**

This application provides a shielding apparatus and an electronic device. In the shielding apparatus, an outer surface of a component of a camera module is covered with a conducting layer, a support element is filled with a conductive structure, and the conducting layer, the conductive structure, and a substrate are connected, so that a lens barrel, the support element, and the substrate are electrically connected. In this way, a relatively complete Faraday cage is formed, thereby achieving a shielding effect of shielding an electromagnetic signal. In addition, because there is no need to provide a shielding case outside the entire camera module, a size of the shielding apparatus can effectively be reduced without affecting appearance of an original structure. Moreover, compared with a prior-art solution in which a shielding case is formed after a camera module is assembled, the shielding apparatus in this application can be assembled in parts. In this way, a processing period prolonged because of a process of finally forming a shielding case can be shortened. In addition, an additional processing error caused by the process of finally forming the shielding case can be reduced, so as to increase a product qualification rate of camera modules.

## Description

This application claims priority to Chinese Patent Application No. 201911203745.7, filed with the Chinese Patent Office on November 29, 2019 and entitled "SHIELDING APPARATUS AND ELECTRONIC DEVICE", which is incorporated herein by reference in its entirety.

### TECHNICAL FIELD

This application relates to the field of electronic devices, and more specifically, to a shielding apparatus and an electronic device.

### BACKGROUND

Currently, increasing electronic devices such as mobile phones, tablet computers, and notebook computers are provided with camera components. As requirements of consumers for visualization gradually become higher, a volume of data transmitted by a camera module gradually increases. However, an ever-increasing volume of the data transmitted by the camera module causes interference to communication quality of an electronic device. In addition, high-power communication transmission of the electronic device causes interference to image data transmission of the camera module. Therefore, a shielding technology needs to be used for the camera module, to resolve an electromagnetic interference (electromagnetic interference, EMI) problem caused in an operating process of the camera module.

### SUMMARY

This application provides a shielding apparatus and an electronic device. In the shielding apparatus, an outer surface of a component of a camera module is covered with a conducting layer, a support element is filled with a conductive structure, and the conducting layer, the conductive structure, and a substrate are connected, so that a lens barrel, the support element, and the substrate are electrically connected. In this way, a relatively complete Faraday cage is formed, thereby achieving a shielding effect of shielding an electromagnetic signal.

In addition, because there is no need to provide a shielding case outside the entire camera module, a size of the shielding apparatus can effectively be reduced without affecting appearance of an original structure.

Moreover, compared with a prior-art solution in which a shielding case is formed after a camera module is assembled, the shielding apparatus in this application can be assembled in parts. In this way, a processing period prolonged because of a process of finally forming a shielding case can be shortened. In addition, an additional processing error caused by the process of finally forming the shielding case can be reduced, so as to increase a product qualification rate of camera modules.

According to a first aspect, a shielding apparatus is provided. The shielding apparatus includes a lens component, a support element, and a substrate, where
the lens component includes a lens barrel and an optical lens assembly, the lens barrel is of a cylindrical structure, the lens barrel includes an optical channel penetrating through the lens barrel and forms two ends provided with openings, the optical lens assembly is disposed at one end that is of the lens barrel and that is provided with an opening, to allow light to enter the optical channel through the optical lens assembly, and the lens barrel is made of a material having no conductive property and an outer surface of the lens barrel is covered with a first conducting layer; and
the support element is disposed between the lens barrel and the substrate, the support element is made of a material having no conductive property, the support element is filled with at least one first conductive structure, a first end part of the first conductive structure is connected to the first conducting layer, and a second end part of the first conductive structure is connected to exposed metal of the substrate.

Therefore, in the shielding apparatus provided in this application, the outer surface of the lens barrel is covered with the first conducting layer, and the support element is filled with the first conductive structure, so that the lens barrel and the support element each have a shielding function. In addition, the lens barrel, the support element, and the substrate are connected by using the first conductive structure, so that the lens barrel, the support element, and the substrate are electrically connected by using an electrical connection between the first conducting layer, the first conductive structure, and the substrate. In this way, the shielding apparatus is grounded, and a complete Faraday cage is formed on a camera module, to assemble the camera module into a new shielding apparatus for shielding an electromagnetic signal, thereby achieving a relatively desirable shielding effect.

In addition, in the shielding apparatus in this application, the lens barrel is covered with the first conducting layer, and the support element is filled with the first conductive structure. In this way, a relatively large shielding case that can accommodate the camera module may not need to be provided outside the entire camera module. Therefore, a size of the shielding apparatus can effectively be reduced without affecting appearance of an original structure.

In addition, compared with a prior-art solution in which a shielding case is formed after a camera module is assembled, the shielding apparatus in this application can be assembled in parts. To be specific, the outer surface of the lens barrel of the camera module is covered with the first conducting layer, the support element is filled with the first conductive structure, and the first conductive structure is connected to the first conducting layer for assembly to form the shielding apparatus including the camera module and a complete shielding structure. In this way, a processing period prolonged because of a process of finally forming a shielding case can be shortened. In addition, an additional processing error caused by the process of finally forming the shielding case can be reduced, so as to increase a product qualification rate of camera modules.

Optionally, at least one first through hole penetrating through the support element is disposed in the support element, and the first through hole is filled with the first conductive structure.

Optionally, the first through hole is an open hole disposed at an edge of the support element.

Edge holes of different sizes may be provided depending on a requirement by forming the holes at the edge of the support element, and are filled with the conductive structure. When there is another object around the support element, interference to the support element and the conductive structure can be avoided. In addition, a contact area between the conductive structure and the support element can be increased without affecting strength or rigidity of the support element. Moreover, a construction difficulty of the conductive structure can be reduced.

Optionally, a first through hole penetrating through the support element is disposed inside the support element, and each end part of the first conductive structure is formed by a plurality of convex structures.

Each end part of the first conductive structure is set as an end part formed by the plurality of convex structures. This can simplify processing of the conductive structure, facilitating production.

Optionally, the shielding apparatus further includes a plastic package assembly disposed between the support element and the substrate, and the first conductive structure penetrates through the plastic package assembly.

Optionally, the first end part of the first conductive structure is connected to the first conducting layer by using a conductive adhesive.

In this way, the first conductive structure is connected to a first end part of the first conducting layer by using the conductive adhesive, so as to improve electrical connection stability.

Optionally, the second end part of the first conductive structure is connected to a ground pad of the substrate.

Optionally, the first conductive structure is a structure formed by a conductive adhesive, or a metal dome.

According to a second aspect, a shielding apparatus is provided. The shielding apparatus includes a lens component, a support element, a plastic package assembly, and a substrate, where
the lens component includes a lens barrel and an optical lens assembly, the lens barrel is of a cylindrical structure, the lens barrel includes an optical channel penetrating through the lens barrel and forms two ends provided with openings, the optical lens assembly is disposed at one end that is of the lens barrel and that is provided with an opening, to allow light to enter the optical channel through the optical lens assembly, and the lens barrel is made of a material having no conductive property and an outer surface of the lens barrel is covered with a first conducting layer;
the support element is disposed between the lens barrel and the plastic package assembly, the support element is made of a material having no conductive property and an outer surface of the support element is covered with a third conducting layer, and the first conducting layer is connected to the third conducting layer; and
the plastic package assembly is disposed between the support element and the substrate, at least one second conductive structure penetrating through the plastic package assembly is formed in the plastic package assembly through plastic packaging, a first end part of the second conductive structure is connected to the third conducting layer, and a second end part of the second conductive structure is connected to exposed metal of the substrate.

Therefore, in the shielding apparatus provided in this application, the outer surfaces of the lens barrel and the support element are covered with the conducting layers (the first conducting layer and the third conducting layer), and the plastic package assembly is filled with the second conductive structure, so that the lens barrel, the support element, and the plastic package assembly each have a shielding function. In addition, the lens barrel, the support element, the plastic package assembly, and the substrate are connected by using the second conductive structure, so that the lens barrel, the support element, the plastic package assembly, and the substrate are electrically connected by using the first conducting layer, the third conducting layer, and a first conductive structure. In this way, the shielding apparatus is grounded, and a complete Faraday cage is formed on a camera module, to assemble the camera module into a new shielding apparatus for shielding an electromagnetic signal, thereby achieving a relatively desirable shielding effect.

In addition, in the shielding apparatus in this application, the lens barrel is covered with the first conducting layer, the support element is covered with a second conducting layer, and the plastic package assembly is filled with the second conductive structure. In this way, a relatively large shielding case that can accommodate the camera module may not need to be provided outside the entire camera module. Therefore, a size of the shielding apparatus can effectively be reduced without affecting appearance of an original structure.

In addition, compared with a prior-art solution in which a shielding case is formed after a camera module is assembled, the shielding apparatus in this application can be assembled in parts. To be specific, the lens barrel of the camera module is covered with the first conducting layer, the support element is covered with the second conducting layer, the plastic package assembly is filled with the second conductive structure, and the second conductive structure, the first conducting layer, and the second conducting layer are connected for assembly to form the shielding apparatus including the camera module and a complete shielding structure. In this way, a processing period prolonged because of a process of finally forming a shielding case can be shortened. In addition, an additional processing error caused by the process of finally forming the shielding case can be reduced, so as to increase a product qualification rate of camera modules. Furthermore, the shielding apparatus in this application does not affect an assembly sequence of the module, and does not additionally increase the size or does not affect the appearance of the original structure.

Optionally, the first end part of the second conductive structure is connected to the third conducting layer by using a conductive adhesive.

In this way, the first end part of the second conductive structure is connected to the third conducting layer by using the conductive adhesive, so as to improve electrical connection stability.

Optionally, the second end part of the second conductive structure is connected to a ground pad of the substrate.

Optionally, the second conductive structure is any one of the following: a structure formed by a conductive adhesive, a metal dome, or a gold ground wire disposed on the ground pad of the substrate.

According to a third aspect, a shielding apparatus is provided. The shielding apparatus includes a lens component, a support element, a plastic package assembly, and a substrate, where
the lens component includes a lens barrel and an optical lens assembly, the lens barrel is of a cylindrical structure, the lens barrel includes an optical channel penetrating through the lens barrel and forms two ends provided with openings, the optical lens assembly is disposed at a first end that is of the lens barrel and that is provided with an opening, to allow light to enter the optical channel through the optical lens assembly, a peripheral edge of a second end that is of the lens barrel and that is provided with an opening forms a raised edge in a direction in which the lens barrel is close to the plastic package assembly, to form, in a middle region of the second end of the lens barrel, a depressed region surrounded by the raised edge, and the lens barrel is made of a material having no conductive property and an outer surface of the lens barrel is covered with a first conducting layer;
the support element is accommodated in the depressed region to enclose the support element by using the raised edge; and
the plastic package assembly is disposed between the lens barrel and the substrate, at least one second conductive structure penetrating through the plastic package assembly is formed in the plastic package assembly through plastic packaging, a first end part of the second conductive structure is connected to the first conducting layer, and a second end part of the second conductive structure is connected to exposed metal of the substrate.

Therefore, in the shielding apparatus provided in this application, the lens barrel encloses and is fixedly connected to the support element, the lens barrel is covered with the first conducting layer, and the plastic package assembly is filled with the second conductive structure, so that the lens barrel and the plastic package assembly each have a shielding function. In addition, the lens barrel, the plastic package assembly, and the substrate are connected by using the second conductive structure, so that the lens barrel, the support element, the plastic package assembly, and the substrate are electrically connected by using the first conducting layer and the second conductive structure. In this way, the shielding apparatus is grounded, and a complete Faraday cage is formed on a camera module, to assemble the camera module into a new shielding apparatus for shielding an electromagnetic signal, thereby achieving a relatively desirable shielding effect.

In addition, in the shielding apparatus in this application, the lens barrel is covered with the first conducting layer, and the plastic package assembly is filled with the second conductive structure. In this way, a relatively large shielding case that can accommodate the camera module may not need to be provided outside the entire camera module. Therefore, a size of the shielding apparatus can effectively be reduced without affecting appearance of an original structure.

In addition, compared with a prior-art solution in which a shielding case is formed after a camera module is assembled, the shielding apparatus in this application can be assembled in parts. To be specific, the outer surface of the lens barrel of the camera module is covered with the first conducting layer, the plastic package assembly is filled with the second conductive structure, and the first conducting layer is connected to the second conductive structure for assembly to form the shielding apparatus including the camera module and a complete shielding structure. In this way, a processing period prolonged because of a process of finally forming a shielding case can be shortened. In addition, an additional processing error caused by the process of finally forming the shielding case can be reduced, so as to increase a product qualification rate of camera modules.

Optionally, the first end part of the second conductive structure is connected to the first conducting layer by using a conductive adhesive.

In this way, the first end part of the second conductive structure is connected to the first conducting layer by using the conductive adhesive, so as to improve electrical connection stability.

Optionally, the second end part of the second conductive structure is connected to a ground pad of the substrate.

Optionally, the second conductive structure is any one of the following: a structure formed by a conductive adhesive, a metal dome, or a gold ground wire disposed on the ground pad of the substrate.

According to a fourth aspect, a shielding apparatus is provided. The shielding apparatus includes a lens component, a support element, and a substrate, where
the lens component includes a lens barrel and an optical lens assembly, the lens barrel is of a cylindrical structure, the lens barrel includes an optical channel penetrating through the lens barrel and forms two ends provided with openings, the optical lens assembly is disposed at one end that is of the lens barrel and that is provided with an opening, to allow light to enter the optical channel through the optical lens assembly, and the lens barrel is made of a composite material having a conductive property; and
the support element is disposed between the lens barrel and the substrate, the support element is made of a composite material having a conductive property, the support element is connected to the lens barrel, and the support element is connected to exposed metal of the substrate.

Therefore, in the shielding apparatus provided in this application, the lens barrel and the support element may be made of the composite materials having conductive properties, and the lens barrel, the support element, and the substrate are connected, so that the lens barrel, the support element, and the substrate can be electrically connected. In this way, the shielding apparatus is grounded, and a complete Faraday cage is formed on a camera module, to assemble the camera module into a new shielding apparatus for shielding an electromagnetic signal, thereby achieving a relatively desirable shielding effect.

In addition, in the shielding apparatus in this application, the lens barrel and the support element are made of the composite materials containing conductive materials. In this way, a relatively large shielding case that can accommodate the camera module may not need to be provided outside the entire camera module. Therefore, a size of the shielding apparatus can effectively be reduced without affecting appearance of an original structure.

Moreover, compared with a prior-art solution in which a shielding case is formed after a camera module is assembled, the shielding apparatus in this application can be assembled in parts. In this way, a processing period prolonged because of a process of finally forming a shielding case can be shortened. In addition, an additional processing error caused by the process of finally forming the shielding case can be reduced, so as to increase a product qualification rate of camera modules.

Optionally, the shielding apparatus further includes a plastic package assembly disposed between the support element and the substrate, at least one second conductive structure penetrating through the plastic package assembly is formed in the plastic package assembly through plastic packaging, a first end part of the second conductive structure is connected to the support element, and a second end part of the second conductive structure is connected to the exposed metal of the substrate.

Optionally, the first end part of the second conductive structure is connected to the first conducting layer by using a conductive adhesive.

Optionally, the second end part of the second conductive structure is connected to a ground pad of the substrate.

Optionally, a material having a conductive property in the composite material may be any one of stainless steel fiber, nickel fiber, carbon fiber, and carbon nanotubes.

According to a fifth aspect, a shielding apparatus is provided. The shielding apparatus includes a lens component, a support element, and a substrate, where
the lens component includes a lens barrel and an optical lens assembly, the lens barrel is of a cylindrical structure, the lens barrel includes an optical channel penetrating through the lens barrel and forms two ends provided with openings, the optical lens assembly is disposed at one end that is of the lens barrel and that is provided with an opening, to allow light to enter the optical channel through the optical lens assembly, and the lens barrel is made of a material having no conductive property and an outer surface of the lens barrel is covered with a first conducting layer; and
the support element is disposed between the lens barrel and the substrate, the support element is made of a material having no conductive property and an outer surface of the support element is covered with a third conducting layer, one end of the third conducting layer is connected to the first conducting layer, and the other end of the third conducting layer is connected to exposed metal of the substrate.

Therefore, in the shielding apparatus provided in this application, the outer surface of the lens barrel is covered with the first conducting layer, the outer surface of the support element is covered with the third conducting layer, and the two ends of the third conducting layer are respectively connected to the first conducting layer and the exposed metal of the substrate, so that the lens barrel, the support element, and the substrate are electrically connected. In this way, a relatively complete Faraday cage is formed on a camera module, to assemble the camera module into a new shielding apparatus for shielding an electromagnetic signal.

In addition, in the shielding apparatus in this application, the lens barrel is covered with the first conducting layer, and the support element is covered with the third conducting layer. In this way, a relatively large shielding case that can accommodate the camera module may not need to be provided outside the entire camera module. Therefore, a size of the shielding apparatus can effectively be reduced without affecting appearance of an original structure.

In addition, compared with a prior-art solution in which a shielding case is formed after a camera module is assembled, the shielding apparatus in this application can be assembled in parts. To be specific, the outer surface of the lens barrel of the camera module is covered with the first conducting layer, the outer surface of the support element is covered with the third conducting layer, and the first conducting layer is connected to a second conductive structure for assembly to form the shielding apparatus including the camera module and a complete shielding structure. In this way, a processing period prolonged because of a process of finally forming a shielding case can be shortened. In addition, an additional processing error caused by the process of finally forming the shielding case can be reduced, so as to increase a product qualification rate of camera modules.

According to a sixth aspect, a shielding apparatus is provided. The shielding apparatus includes a lens component and a substrate, where
the lens component is disposed on one side of the substrate and includes a lens barrel and an optical lens assembly, the lens barrel is connected to the substrate, the lens barrel is of a cylindrical structure, the lens barrel includes an optical channel penetrating through the lens barrel and forms two ends provided with openings, the optical lens assembly is disposed at one end that is of the lens barrel and that is provided with an opening, to allow light to enter the optical channel through the optical lens assembly, the lens barrel is made of a material having no conductive property and an outer surface of the lens barrel is covered with a first conducting layer, the outer surface of the lens barrel includes a side face in a circumferential direction of the lens barrel and a top face that is perpendicular to a first direction and that is away from the substrate, the circumferential direction of the lens barrel is around the first direction, and the first direction is perpendicular to the substrate; and
an outer surface of the substrate is covered with a second conducting layer, the second conducting layer is connected to the first conducting layer, the outer surface of the substrate includes a side face in a circumferential direction of the substrate and a bottom face that is perpendicular to the first direction and that is away from the lens barrel assembly, there is exposed metal on the bottom face of the substrate, and the circumferential direction of the substrate is around the first direction.

Therefore, in the shielding apparatus provided in this application, a camera module of the shielding apparatus includes two parts connected to each other, a first part includes the lens barrel, a second part includes at least the substrate, the outer surface of the first part is covered with the first conducting layer, an outer surface of the second part is covered with the second conducting layer, and the first conducting layer is connected to the second conducting layer to form a shielding structure wrapped outside the camera module. In this way, the shielding structure formed by the first conducting layer and the second conducting layer can be electrically connected to the substrate, so that the shielding apparatus is grounded, and a complete Faraday cage is formed outside the camera module, thereby achieving a shielding effect of shielding an electromagnetic signal.

In addition, the first conducting layer is connected to the second conducting layer and is connected to the metal of the substrate, and a second conductor layer covers the outer surface of the substrate, so that a straight-line shaped metal structure of the substrate can be expanded to a metal structure of a U-shaped structure. In this way, a metal area of the substrate and a heat dissipation area are increased, thereby improving a heat dissipation effect of the entire shielding apparatus.

In addition, the second conducting layer is stably connected to the first conducting layer, so that the two conductive substances can directly be bonded without requiring other electrical connection measures. In this way, an excellent conductive property and low contact resistance are implemented.

Optionally, a first end part that is of the second conducting layer and that is close to the first conducting layer is set to be of a step-shaped structure, a first end part that is of the first conducting layer and that is close to the second conducting layer is set to be of a structure in cooperation with the step-shaped structure, and the first end part of the first conducting layer is connected to the first end part of the second conducting layer.

By using this structure in which the first conducting layer is connected to the second conducting layer by using the step-shaped structure, a contact area between the first conducting layer and the second conducting layer can be increased. In this way, binding force between the first conducting layer and the second conducting layer is increased, and the connection is more firm.

Optionally, the first end part of the second conducting layer is set to be of a step-shaped structure with an L-shaped cross section, and the first end part of the first conducting layer is connected to and accommodated in the first end part of the second conducting layer.

Optionally, at least one groove is disposed in the bottom face of the substrate, and the second conducting layer extends to the groove to fill the groove.

Optionally, the shielding apparatus further includes a support element disposed between the substrate and the lens barrel, the second conducting layer further covers a side face that is of the support element and that is in a circumferential direction of the support element, and the circumferential direction of the support element is around the first direction.

Optionally, the shielding apparatus further includes a plastic package assembly disposed between the substrate and the lens barrel, the second conducting layer further covers a side face that is of the plastic package assembly and that is in a circumferential direction of the plastic package assembly, and the circumferential direction of the plastic package assembly is around the first direction.

According to a seventh aspect, an electronic device is provided, where the electronic device includes an antenna and the shielding apparatus in any possible implementations of any one of the foregoing aspects.

### BRIEF DESCRIPTION OF DRAWINGS

FIG. 1 is a schematic structural diagram of an electronic device according to this application;
FIG. 2 is a schematic structural diagram of a shielding apparatus according to this application;
FIG. 3 is a schematic principle diagram of a shielding apparatus according to this application;
FIG. 4(a) and FIG. 4(b) are another schematic structural diagram of a shielding apparatus according to this application;
FIG. 5(a) and FIG. 5(b) are another schematic structural diagram of a shielding apparatus according to this application;
FIG. 6(a) to FIG. 6(c) are another schematic structural diagram of a shielding apparatus according to this application;
FIG. 7 is another schematic structural diagram of a shielding apparatus according to this application;
FIG. 8 is another schematic structural diagram of a shielding apparatus according to this application;
FIG. 9 is another schematic structural diagram of a shielding apparatus according to this application;
FIG. 10 is another schematic structural diagram of a shielding apparatus according to this application;
FIG. 11 is another schematic structural diagram of a shielding apparatus according to this application;
FIG. 12(a) and FIG. 12(b) are another schematic structural diagram of a shielding apparatus according to this application;
FIG. 13(a) and FIG. 13(b) are another schematic structural diagram of a shielding apparatus according to this application;
FIG. 14 is another schematic structural diagram of a shielding apparatus according to this application;
FIG. 15 is another schematic structural diagram of a shielding apparatus according to this application; and
FIG. 16 is another schematic structural diagram of a shielding apparatus according to this application.

### Reference numerals:

211: optical lens assembly; 212: lens barrel; 2121: optical channel; 220: support element; 230: light filter; 240: substrate; 250: plastic package assembly;
261: first conducting layer; 263: second conducting layer; 262: third conducting layer; 264: first conductive structure; 265: second conductive structure; 266: conductive structure between the lens barrel and the support element; 267: conductive structure between the support element and the substrate; 268: conductive structure between the support element and the plastic package assembly;
212-A: side face of the lens barrel; 212-C: top face of the lens barrel; 220-A: side face of the support element; 250-A: side face of the plastic package assembly; 240-B: bottom face of the substrate; 241-A: side face of the substrate.

### DESCRIPTION OF EMBODIMENTS

The following describes technical solutions of this application with reference to accompanying drawings.

In this application, unless otherwise clearly specified and limited, terms such as "connection", "fixed connection", and "contact" should be interpreted in a broad sense. A person of ordinary skill in the art can understand specific meanings of the foregoing terms in the embodiments of this application according to specific circumstances.

For example, the "connection" may include various connection manners such as a fixed connection, a rotational connection, a flexible connection, a mobile connection, integrated molding, and an electrical connection, or may include a direct connection, an indirect connection implemented through an intermediary, an internal connection between two elements, or an interaction between two elements.

In this application, unless otherwise specified, a connection usually indicates a mechanical connection. An electrical connection that needs to be indicated will be particularly described.

For example, the term "fixed connection" may mean that one element is directly or indirectly fixedly connected to another element. The fixed connection may include manners such as a mechanical connection, welding, and bonding. The mechanical connection may include manners such as riveting, a bolted connection, a threaded connection, a key pin connection, a buckle connection, a latch connection, and a plug connection. The bonding may include manners such as adhesive bonding and solvent bonding.

For example, the term "contact" may be interpreted as direct or indirect contact between one element and another element. In addition, contact between two elements described in the embodiments of this application may be understood as contact within an allowed installation error range, and a quite small gap caused due to an installation error may exist.

It should also be understood that "parallel" or "perpendicular" described in the embodiments of this application may be understood as "approximately parallel" or "approximately perpendicular".

It should also be understood that, orientations or position relationships indicated by terms such as "center", "longitudinal", "transverse", "length", "width", "thickness", "upper", "lower", "front", "back", "left", "right", "vertical", "horizontal", "top", "bottom", "inside", and "outside" are orientations or position relationships based on illustrations in the accompanying drawings. The terms are merely intended to facilitate and simplify the descriptions of this application, but are not intended to indicate or imply that an indicated apparatus or element needs to have a particular orientation and needs to be constructed and operated in a particular orientation, and therefore cannot be construed as a limitation on this application.

It should be noted that terms "first" and "second" are merely intended for a purpose of description, and shall not be understood as an indication or implication of relative importance or implicit indication of the number of indicated technical features. The feature limited by "first" or "second" may explicitly or implicitly include one or more features.

It should also be noted that, in the embodiments of this application, same reference signs are used to represent same components or same parts. For same parts in the embodiments of this application, an example in which only one of the parts or components is marked with a reference sign may be used in the figure. It should be understood that the reference sign is also applicable to other same parts or components.

First, a coordinate system of the accompanying drawings in the embodiments of this application is described. Every two of x, y, and z directions are perpendicular. The x direction may be understood as a length direction of a shielding apparatus, the y direction may be understood as a width direction of the shielding apparatus, and the z direction may be understood as a height direction of the shielding apparatus. The height direction of the shielding apparatus is a stacking direction of components in the shielding apparatus. In other words, the components of the shielding apparatus are stacked in the z direction.

The shielding apparatus in this application may be a shielding apparatus with a camera module, and the shielding apparatus may be installed in various electronic devices. An electronic device may be a mobile phone, a smartphone (smart phone), a tablet computer, a handheld computer, a laptop computer (laptop computer), a video camera, a video recorder, a camera, a smartwatch (smart watch), a smart band (smart wristband), or a device in another form. A specific form of the electronic device is not particularly limited in the embodiments of this application. For ease of description and understanding, the following provides a description by using an example in which an electronic device 100 is a mobile phone.

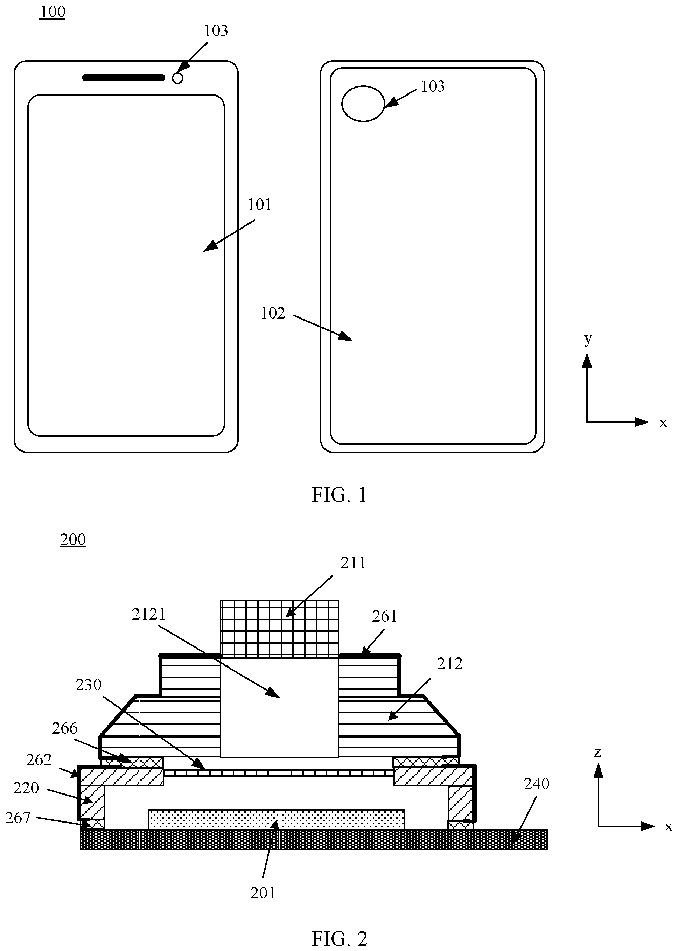

FIG. 1 is a schematic structural diagram of an electronic device. As shown in FIG. 1, the electronic device 100 may include a display (display panel, DP) 101, a casing 102, a shielding apparatus 103, an antenna (not shown in the figure), and the like. Accommodating space is formed in the casing 102, and the display 101 and the shielding apparatus 103 are disposed in the accommodating space of the casing 102. The display 101 may be a liquid crystal display (liquid crystal display, LCD), an organic light-emitting diode (organic light emitting diode, OLED) display, or the like. The OLED display may be a flexible display or a rigid display.

The shielding apparatus 103 with a camera module may be disposed only on a front face of the electronic device 100, and is configured to photograph scenery on a front side of the electronic device 100. In some embodiments, the camera module may be referred to as a front-facing camera. Alternatively, the camera module 103 may be disposed only on a rear face of the electronic device 100, and is configured to photograph scenery on a rear side of the electronic device 100. In some embodiments, alternatively, the camera module may be referred to as a rear-facing camera. Alternatively, the camera module 103 may be disposed on a front face and a rear face of the electronic device 100. As shown in FIG. 1, the front face of the electronic device 100 is provided with the shielding apparatus 103, and the rear face of the electronic device 100 is also provided with the shielding apparatus 103. In this way, the scenery on the front side of the electronic device 100 can be photographed, and the scenery on the rear side of the electronic device 100 can also be photographed, provided that a corresponding shielding apparatus is used during photographing.

It should be understood that an installation position of the shielding apparatus 103 is merely used as an example, and the screen apparatus 103 may be installed at any possible position on the electronic device 100. This is not limited in this application.

A quantity of shielding apparatuses 103 that are disposed is not limited in this embodiment of this application. There may be one, two, four, or even more shielding apparatuses 103. It should be noted that, in this embodiment of this application, the front face of the electronic device 100 may be understood as a side surface that is of the electronic device 100 and that faces a user when the user uses the electronic device 100, and the rear face of the electronic device 100 may be understood as a side surface that is of the electronic device 100 and that faces away from the user when the user uses the electronic device 100.

It should be understood that, in addition to the foregoing components, the electronic device 100 shown in FIG. 1 may further include other components such as a battery, a flash, a fingerprint recognition module, an earpiece, a key, and a sensor. In this embodiment of this application, only the electronic device on which the shielding apparatus 103 is installed is used as an example for description. However, components installed on the electronic device 100 are not limited thereto.

This application provides a shielding apparatus. The shielding apparatus includes a camera module. An outer surface of a component of the camera module is covered with a conducting layer or a component is fabricated by using a material having a conductive property, various components are separately assembled, and the components are connected by using a conductive structure. In this way, a relatively complete Faraday cage is formed, thereby achieving a shielding effect of shielding an electromagnetic signal. In addition, because there is no need to provide a shielding case outside the entire camera module, a size of the shielding apparatus can effectively be reduced without affecting appearance of an original structure. In addition, the foregoing structure is formed by performing assembly in pieces. In this way, a processing period prolonged because of a process of finally forming a shielding case can be shortened. In addition, an additional processing error caused by the process of finally forming the shielding case can be reduced, so as to increase a product qualification rate of camera modules.

In addition, this application further provides another shielding apparatus. A camera module of the shielding apparatus includes two parts connected to each other. An outer surface of a first part is covered with a first conducting layer, an outer surface of a second part is covered with a second conducting layer, and the first conducting layer is connected to the second conducting layer to form a shielding structure wrapped outside the camera module. In this way, a complete Faraday cage is formed, thereby achieving a shielding effect of shielding an electromagnetic signal.

It should be noted that, in a structure in this application in which the component is covered with the conducting layer, the conductor layer and the component are basically closely attached without a gap, and the conducting layer may be formed on the component by using a technology such as spraying, sputtering, transfer printing, or laser direct structuring (laser direct structuring, LDS).

The following details a shielding apparatus in this application with reference to FIG. 2 to FIG. 16.

It should be noted that an upper surface and a lower surface of a component in this application mean: A substrate is used as a reference, both the upper surface and the lower surface are approximately parallel to the substrate, a surface that is of the component and that is close to the substrate may be understood as the lower surface, and a surface that is of the component and that is away from the substrate may be understood as the upper surface. A cylindrical structure in this application may be a structure in a regular shape. For example, the cylindrical structure is a cylinder or a circular cylinder. The cylindrical structure may alternatively be a structure in an irregular shape. This is not limited in the embodiments of this application.

It should also be noted that a connection between two components in this application may be a direct connection, or may be an indirect connection implemented through an intermediary. For example, a connection between a first conducting layer and a second conducting layer (or a first conductive structure) may be a connection implemented through direct contact thereof, or a connection between a first conducting layer and a second conducting layer (or a first conductive structure) may be a connection implemented by using a conductive material or a conductive structure.

FIG. 2 is a schematic structural diagram of a shielding apparatus according to this application. Referring to FIG. 2, the shielding apparatus 200 includes a camera module and a shielding structure formed on the camera module by using a conductive material. The camera module may include a lens component, a support element 220, a substrate 240, and a light filter 230 enclosed by the support element 220 that are successively disposed along a z direction from top to bottom, and the shielding structure may include a first conducting layer 261, a third conducting layer 262, a conductive structure 266, and a conductive structure 267.

The lens component includes an optical lens assembly 211 and a lens barrel 212, the lens barrel 212 is of a cylindrical structure, the lens barrel 212 includes an optical channel 2121 penetrating through the lens barrel 212 and forms two ends provided with openings, and the optical lens assembly 211 is disposed at one end (denoted as a first end) that is of the lens barrel 212 and that is provided with an opening, to allow light to enter the optical channel 2121 through the optical lens assembly 211. The support element 220 and the light filter 230 are disposed at the other end (denoted as a second end) that is of the lens barrel 212 and that is provided with an opening, the support element 220 is of a cylindrical structure, the support element 220 encloses and is connected to the light filter 230, and the light filter 230 and the optical channel 2121 are disposed opposite to each other to allow light to enter the light filter 230 through the optical channel 2121. The substrate 240 is disposed at one end that is of the support element 220 and that is away from the lens component, a structure having a conductive property such as a ground pad is disposed on the substrate 240, and the substrate 240 is connected to elements such as a printed circuit board (printed circuit board, PCB), a flexible printed circuit board (flexible printed circuit, FPC), various passive components (such as a capacitor, a resistor, and an inductor), and various chips 201 (such as a sensor chip).

The lens barrel 212 is made of a material having no conductive property, and an outer surface of the lens barrel 212 is covered with the first conducting layer 261. For example, the material having no conductive property may be plastic such as polycarbonate (polycarbonate, PC) or polyamide (polyamide, PA). For example, the conducting layer may be formed on the outer surface of the lens barrel 212 in any one of the following manners: spraying, sputtering, transfer printing, or laser direct structuring (laser direct structuring, LD S). For example, the first conducting layer 261 may be made of a material having a conductive property such as metal, a metal compound, or a carbon-based compound. The support element 220 is also made of a material having no conductive property, and an outer surface of the support element 220 is covered with the third conducting layer 262. Related content of a material of the support element 220 and the conducting layer 262 that covers the outer surface of the support element 220 may be similar to that of the lens barrel 212. Details are not described herein again.

The lens barrel 212 and the support element 220 are connected by using the conductive structure 266, and the support element 220 and the substrate 240 are connected by using the conductive structure 267, so that the lens barrel, the support element, and the substrate are electrically connected. The conductive structure 266 or the conductive structure 267 may be made of a material having a conductive property such as a conductive adhesive, metal, a metal compound, or a carbon-based compound, and two components may be connected by using a conductive structure in various possible connection manners such as welding, bonding, and riveting.

For example, the conductive structure 266 may be a structure formed by a conductive adhesive, and both a lower surface of the lens barrel 212 and an upper surface of the support element 220 are attached to the conductive structure 266. For another example, the conductive structure 267 may also be a structure formed by a conductive adhesive, and both a lower surface of the support element 220 and an upper surface of the substrate 240 are attached to the conductive structure 267.

Optionally, the first conducting layer 261 may extend for a specific distance from the outer surface of the lens barrel 212 to the lower surface that is of the lens barrel 212 and that is opposite to the support element 220, and the third conducting layer 262 may extend for a specific distance from the outer surface of the support element 220 to the upper surface that is of the support element 220 and that is opposite to the lens barrel 212, so that the conductive structure 266 is bonded to both a part that is of the first conducting layer 261 and that covers the lower surface of the lens barrel 212 and a part that is of the third conducting layer 262 and that covers the upper surface of the support element 220. In this way, the lens barrel 212 is connected to the support element 220, so that the lens barrel 212 is electrically connected to the support element 220. Similarly, the third conducting layer 262 may extend for a specific distance from the outer surface of the support element 220 to a lower surface that is of the support element 220 and that is opposite to the substrate 240, so that a part that is of the third conducting layer 262 and that covers the lower surface of the support element 220 is bonded to the conductive structure 267. In this way, the substrate 240 is connected to the support element 220, so that the support element 220 is electrically connected to the substrate 240. In this way, a complete Faraday cage can be formed after the shielding apparatus is assembled in parts, thereby achieving a better shielding effect.

In the foregoing shielding apparatus, the outer surface of the lens barrel is covered with the first conducting layer, the outer surface of the support element is covered with the third conducting layer, and two ends of the third conducting layer are respectively connected to the first conducting layer and exposed metal of the substrate, so that the lens barrel, the support element, and the substrate are electrically connected. In this way, a relatively complete Faraday cage is formed on the camera module to assemble the camera module into a new shielding apparatus for shielding an electromagnetic signal.

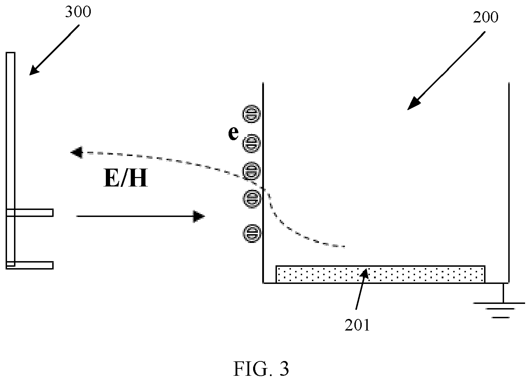

The following briefly describes a shielding principle of the shielding apparatus in this application with reference to FIG. 3. A shielding principle of a shielding apparatus corresponding to each accompanying drawing is the same as the shielding principle described in FIG. 3, and details are not described again subsequently. Referring to FIG. 3, as shown by a solid line, when an antenna 300 generates an electromagnetic wave signal, charges are induced by an electromagnetic field on an outer surface of the shielding apparatus; and when the electromagnetic field changes, the induced charges flow to a substrate ground after passing through a conducting layer, a conductive structure, and a substrate, avoiding interference to a chip 201 in the shielding apparatus 200. Similarly, as shown by a dashed line, when the chip 201 in the shielding apparatus 200 generates an electromagnetic wave, induced charges are generated by the electromagnetic wave inside the shielding apparatus; and when the electromagnetic wave changes, the induced charges flow to the substrate ground after passing through the conducting layer, the conductive structure, and the substrate, avoiding interference to a sensitive device such as a receive antenna of a mobile phone.

In addition, in the shielding apparatus in this application, the lens barrel is covered with the first conducting layer, and the support element is covered with the third conducting layer. In this way, a relatively large shielding case that can accommodate the camera module may not need to be provided outside the entire camera module. Therefore, a size of the shielding apparatus can effectively be reduced without affecting appearance of an original structure. In addition, compared with a prior-art solution in which a shielding case is formed after a camera module is assembled, the shielding apparatus in this application can be assembled in parts. To be specific, the outer surface of the lens barrel of the camera module is covered with the first conducting layer, the outer surface of the support element is covered with the third conducting layer, and the first conducting layer is connected to a second conductive structure for assembly to form the shielding apparatus including the camera module and the complete shielding structure. In this way, a processing period prolonged because of a process of finally forming a shielding case can be shortened. In addition, an additional processing error caused by the process of finally forming the shielding case can be reduced, so as to increase a product qualification rate of camera modules.

It should be understood that, the structure in which the outer surfaces of the lens barrel 212 and the support element 220 are covered with the conducting layers to achieve a shielding effect is merely used as an example for description, and should not constitute any limitation on this application. For example, the lens barrel 212 and the support element 220 may alternatively be made of a composite material having a conductive property, and a conductive material may be filled in plastics to form conductive plastics. In this structure, the lens barrel and the support element can be used as a part of the shielding structure, the support element 220 and the lens barrel 212 are connected by using the conductive structure 266, and the support element 220 and the substrate 267 are connected by using the conductive structure 267. Optionally, the conductive material filled in the lens barrel and the support element may be any one of stainless steel fiber, nickel fiber, carbon fiber, and carbon nanotubes.

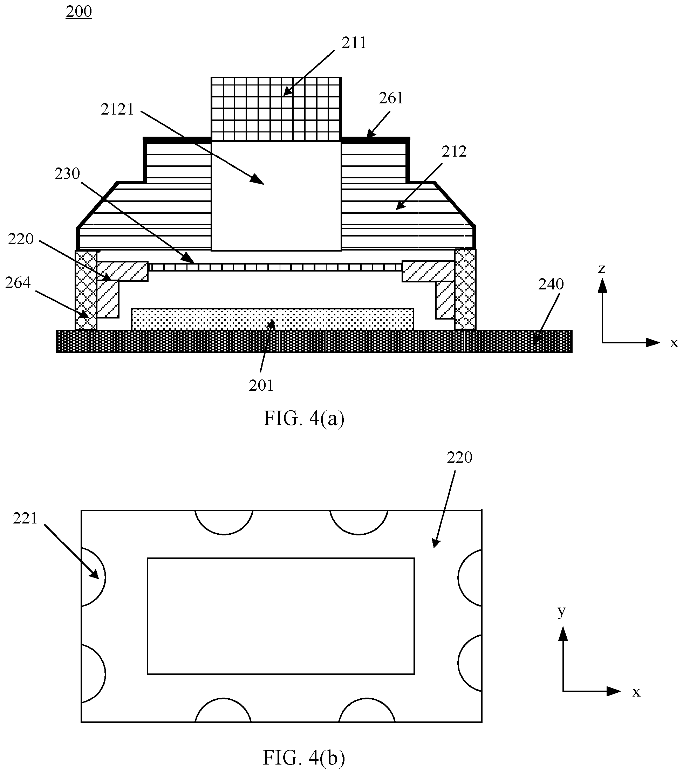

In the structure shown in FIG. 2, the outer surfaces of the lens barrel and the support element are covered with the conducting layers, and the components are connected by using the conductive structures. In some embodiments, the outer surface of the support element may not need to be covered with a conducting layer. A conductive structure may be filled in the support element, and the support element is connected to both the lens barrel and the substrate by using the conductive structure. In this way, a relatively complete Faraday cage is formed, thereby achieving a shielding effect of the shielding apparatus. With reference to FIG. 4(a) to FIG. 7, the following describes the shielding apparatus in which the support element is filled with the conductive structure. In addition, the conductive structure filled in the support element is denoted as a first conductive structure.

FIG. 4(a) and FIG. 4(b) are another schematic structural diagram of a shielding apparatus according to this application. FIG. 4(a) is a sectional view of the shielding apparatus on an xz plane, and FIG. 4(b) is a schematic structural diagram of a support element on a yz plane.

Referring to FIG. 4(a) and FIG. 4(b), the shielding apparatus 200 includes a camera module and a shielding structure. The camera module includes a lens component, the support element 220, a substrate 240, and a light filter 230 enclosed by the support element 220 that are successively disposed along a z direction from top to bottom, and the shielding structure includes a first conducting layer 261 and at least one first conductive structure 264.

Referring to FIG. 4(a), the lens component includes an optical lens assembly 211 and a lens barrel 212, the lens barrel 212 is of a cylindrical structure, the lens barrel 212 includes an optical channel 2121 penetrating through the lens barrel 212 and forms two ends provided with openings, and the optical lens assembly 211 is disposed at a first end that is of the lens barrel 212 and that is provided with an opening, to allow light to enter the optical channel 2121 through the optical lens assembly 211. The support element 220 and the light filter 230 are disposed at a second end that is of the lens barrel 212 and that is provided with an opening, the support element 220 is of a cylindrical structure, the support element 220 encloses and is connected to the light filter 230, and the light filter 230 and the optical channel 2121 are disposed opposite to each other to allow light to enter the light filter 230 through the optical channel 2121. The substrate 240 is disposed at one end that is of the support element 220 and that is away from the lens component, and the substrate 240 is connected to elements such as a PCB, an FPC, various passive components (such as a capacitor, a resistor, and an inductor), and various chips 201 (such as a sensor chip).

Referring to FIG. 4(a), the lens barrel 212 may be made of a material having no conductive property, and an outer surface of the lens barrel 212 is covered with the first conducting layer 261. For specific descriptions about the conducting layer, refer to the related descriptions in FIG. 2. Details are not described again. Referring to FIG. 4(b), the support element 220 may also be made of a material having no conductive property. In addition, at least one first through hole 221 is disposed at an edge of the support element 220. The first through hole 221 is an open hole, and the first through hole 221 is filled with the first conductive structure 264. The first conductive structure 264 may be made of a material having a conductive property such as a conductive adhesive, metal, a metal compound, or a carbon-based compound. A first end part of the first conductive structure 264 is connected to the first conducting layer 261, and a second end part of the first conductive structure 264 is connected to exposed metal of the substrate 240. For example, the metal may be copper. In this way, the first conducting layer 261, the first conductive structure 264, and the substrate 240 are electrically connected, so that the shielding apparatus is grounded, and a complete Faraday cage is formed on the camera module, thereby achieving a shielding effect.

In this application, the first conductive structure 264 may be connected to both the first conducting layer 261 and the exposed metal of the substrate 240 in various possible connection manners such as welding, bonding, and riveting.

For example, the second end part of the first conductive structure 264 may extend to a ground pad of the substrate 240, and is connected to the ground pad in a welding manner.

For example, the first conducting layer 261 may extend for a specific distance from the outer surface of the lens barrel 212 to a bottom face that is of the lens barrel 212 and that is opposite to the support element 220, so that the first end part of the first conductive structure 264 is bonded to a part that is of the first conducting layer 261 and that covers the bottom face of the lens barrel 212. In this way, the first conducting layer 261 is connected to the first conductive structure 264. To make the first conducting layer 261 better connected to the first conductive structure 264, optionally, the first end part of the first conductive structure 264 may be connected to the first conducting layer 261 by using a conductive adhesive (not shown in the figure).

In the shielding structure, the outer surface of the lens barrel is covered with the conducting layer, and the support element is filled with the first conductive structure, so that the lens barrel and the support element each have a shielding function. In addition, the two end parts of the first conductive structure are respectively connected to the substrate and the first conducting layer, so that the first conducting layer, the first conductive structure, and the substrate are electrically connected. In this way, the shielding apparatus is grounded, and a complete Faraday cage is formed on the camera module, thereby achieving a shielding effect.

It should be understood that, the structure in which the outer surface of the lens barrel is covered with the conducting layer to achieve a shielding effect is merely used as an example for description, and should not constitute any limitation on this application. For example, the lens barrel may alternatively be made of a composite material having a conductive property, and a conductive material may be filled in plastics to form a connection between conductive plastics, the lens barrel, and the first conductive structure. In this structure, the lens barrel can be used as a part of the shielding structure, and the lens barrel, the first conductive structure, and the substrate can be electrically connected. In this way, the shielding apparatus is grounded, and a complete Faraday cage is formed on the camera module, thereby achieving a shielding effect. Optionally, the conductive material filled in the lens barrel may be any one of stainless steel fiber, nickel fiber, carbon fiber, and carbon nanotubes.

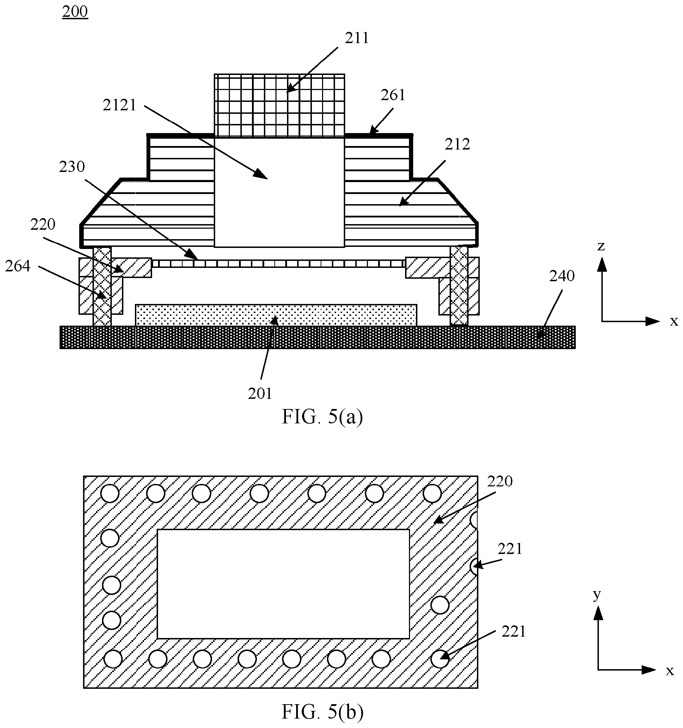

FIG. 5(a) and FIG. 5(b) are another schematic structural diagram of a shielding apparatus according to this application. FIG. 5(a) is a sectional view of the shielding apparatus on an xz plane, and FIG. 5(b) is a schematic sectional view of a support element on a yz plane.

A difference between a structure shown in FIG. 5(a) and FIG. 5(b) and the structure shown in FIG. 4(a) and FIG. 4(b) lies in: A plurality of first through holes 221 may be disposed inside the support element 220 and are complete holes, or some first through holes 221 may be complete holes and some other first through holes 221 may be disposed at an edge of the support element 220 to form open holes. The first through hole 221 may be in various shapes including but not limited to a circular shape. A first conductive structure 264 is filled in the first through hole 221. Two ends of the first conductive structure 264 are respectively connected to a lens barrel 212 and a substrate 240. For specific descriptions about a connection manner thereof, refer to the related descriptions of the embodiment corresponding to FIG. 4(a) and FIG. 4(b). Details are not described again.

It should be understood that, a structure in which an outer surface of the lens barrel is covered with a conducting layer to achieve a shielding effect is merely used as an example for description, and should not constitute any limitation on this application. For example, the lens barrel may alternatively be made of a composite material having a conductive property, and a conductive material may be filled in plastics to form a connection between conductive plastics, the lens barrel, and the first conductive structure. In this structure, the lens barrel can be used as a part of the shielding structure, and the lens barrel, the first conductive structure, and the substrate can be electrically connected. In this way, the shielding apparatus is grounded, and a complete Faraday cage is formed on a camera module, thereby achieving a shielding effect. Optionally, the conductive material filled in the lens barrel may be any one of stainless steel fiber, nickel fiber, carbon fiber, and carbon nanotubes.

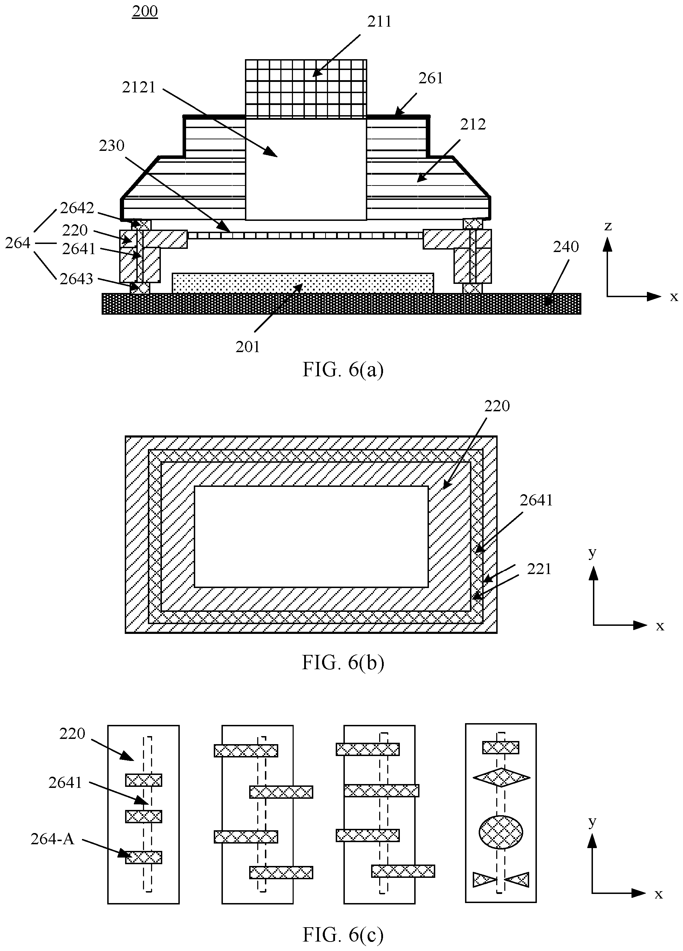

FIG. 6(a) to FIG. 6(c) are another schematic structural diagram of a shielding apparatus according to this application. FIG. 6(a) is a sectional view of the shielding apparatus on an xz plane, FIG. 6(b) is a schematic sectional view of a support element on a yz plane, and FIG. 6(c) is a schematic structural diagram of a local region of the support element on the yz plane.

A difference between a structure shown in FIG. 6(a) to FIG. 6(c) and the structure shown in FIG. 4(a) and FIG. 4(b) lies in: The support element 220 is provided with a first through hole 221. The first through hole 221 penetrates through the support element 220 in a z direction and is around the support element 220 in a circumferential direction of the support element 220. The first through hole 221 is filled with a first conductive structure 264. The first conductive structure 264 may include a main body 2641 and two end parts (denoted as a first end part 2642 and a second end part 2643). Optionally, the main body 2641, the first end part 2642, and the second end part 2643 may be integrated, or may be assembled in parts. This is not limited in this application. The main body 2641 is embedded in the first through hole 221. The two end parts are respectively located on an upper surface and a lower surface of the support element 220, and are respectively connected to a first conducting layer 261 and exposed metal of a substrate 240. For specific descriptions about a connection manner thereof, refer to the related descriptions of the embodiment corresponding to FIG. 4(a) and FIG. 4(b). Details are not described again.

Optionally, either the first end part 2642 or the second end part 2643 may be formed by a plurality of convex structures 264-A, and shapes of the plurality of convex structures 264-A may be identical or different, and the first end part 2642 or the second end part 2643 may be a combination of convex structures 264-A in various shapes. Referring to FIG. 6(c), a shape of the convex structure 264-A may be, for example, any one of the following shapes: a square, a rhombus, a circle, and a triangle, and a shape of the first end part 2642 or the second end part 2643 may be any combination of the foregoing several shapes.

It should be understood that, a structure in which an outer surface of a lens barrel is covered with the conducting layer to achieve a shielding effect is merely used as an example for description, and should not constitute any limitation on this application. For example, the lens barrel may alternatively be made of a composite material having a conductive property, and a conductive material may be filled in plastics to form a connection between conductive plastics, the lens barrel, and the first conductive structure. In this structure, the lens barrel can be used as a part of the shielding structure, and the lens barrel, the first conductive structure, and the substrate can be electrically connected. In this way, the shielding apparatus is grounded, and a complete Faraday cage is formed on a camera module, thereby achieving a shielding effect. Optionally, the conductive material filled in the lens barrel may be any one of stainless steel fiber, nickel fiber, carbon fiber, and carbon nanotubes.

In the shielding apparatus, the outer surface of the lens barrel is covered with the first conducting layer, and the support element is filled with the first conductive structure, so that the lens barrel and the support element each have a shielding function. In addition, the lens barrel, the support element, and the substrate are connected by using the first conductive structure, so that the lens barrel, the support element, and the substrate are electrically connected by using an electrical connection between the first conducting layer, the first conductive structure, and the substrate. In this way, the shielding apparatus is grounded, and a complete Faraday cage is formed on the camera module, to assemble the camera module into a new shielding apparatus for shielding an electromagnetic signal, thereby achieving a relatively desirable shielding effect.

In addition, in the shielding apparatus in this application, the lens barrel is covered with the first conducting layer, and the support element is filled with the first conductive structure. In this way, a relatively large shielding case that can accommodate the camera module may not need to be provided outside the entire camera module. Therefore, a size of the shielding apparatus can effectively be reduced without affecting appearance of an original structure.

In addition, compared with a prior-art solution in which a shielding case is formed after a camera module is assembled, the shielding apparatus in this application can be assembled in parts. To be specific, the outer surface of the lens barrel of the camera module is covered with the first conducting layer, the support element is filled with the first conductive structure, and the first conductive structure is connected to the first conducting layer for assembly to form the shielding apparatus including the camera module and the complete shielding structure. In this way, a processing period prolonged because of a process of finally forming a shielding case can be shortened. In addition, an additional processing error caused by the process of finally forming the shielding case can be reduced, so as to increase a product qualification rate of camera modules.

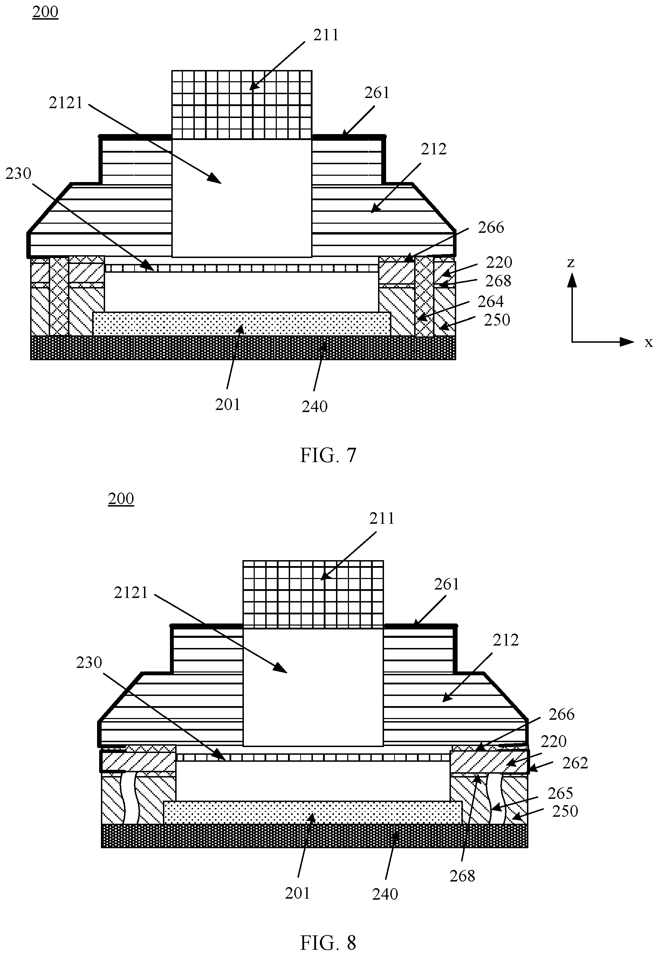

FIG. 7 is another schematic structural diagram of a shielding apparatus according to this application. A difference between a structure shown in FIG. 7 and the structures shown in FIG. 2 to FIG. 6(a) to FIG. 6(c) lies in: The shielding apparatus further includes a plastic package assembly 250 disposed between a substrate 240 and a support element 220, elements such as a wire bond (wire bond) and a passive component are formed in the plastic package assembly 250 through plastic packaging, the plastic package assembly 250 is fastened to the substrate 240 in a plastic packaging manner, and the plastic package assembly 250 and the support element 220 may be connected through attachment by using glue 268. A first conductive structure 264 is filled in the support element 220 and the plastic package assembly 250, or the first conductive structure 264 penetrates through the support element 220 and the plastic package assembly 250. A first end part of the first conductive structure 264 is connected to a first conducting layer 261, and a second end part of the first conductive structure 264 is connected to exposed metal of the substrate 240. For specific descriptions about a connection manner thereof, refer to the related descriptions of the embodiment corresponding to FIG. 4(a) and FIG. 4(b). Details are not described again.

During assembly, all of the support element 220, the glue 268, and the plastic package assembly 250 may be penetrated in a laser drilling manner until a ground pad of the substrate 240 is reached, to form a through hole, and a conductive material is filled in the through hole to form the first conductive structure 264. In addition, some through holes (as shown in FIG. 5(b)) may be reserved when the support element 240 is formed through die sinking injection molding, so as to reduce a quantity of layers penetrated by a laser. The through holes may be complete holes, or may be open holes disposed at an edge of the support element 240.

It should be understood that, a structure in which an outer surface of a lens barrel is covered with the conducting layer to achieve a shielding effect is merely used as an example for description, and should not constitute any limitation on this application. For example, the lens barrel may alternatively be made of a composite material having a conductive property, and a conductive material may be filled in plastics to form a connection between conductive plastics, the lens barrel, and the first conductive structure. In this structure, the lens barrel can be used as a part of the shielding structure, and the lens barrel, the first conductive structure, and the substrate can be electrically connected. In this way, the shielding apparatus is grounded, and a complete Faraday cage is formed on a camera module, thereby achieving a shielding effect. Optionally, the conductive material filled in the lens barrel may be any one of stainless steel fiber, nickel fiber, carbon fiber, and carbon nanotubes.

In the shielding apparatus, the outer surface of the lens barrel is covered with the first conducting layer, and the support element and the plastic package assembly are filled with the first conductive structure, so that the lens barrel, the support element, and the plastic package assembly each have a shielding function. In addition, the lens barrel, the support element, the plastic package assembly, and the substrate are connected by using the first conductive structure, so that the lens barrel, the support element, the plastic package assembly, and the substrate are electrically connected by using the first conducting layer and the first conductive structure. In this way, the shielding apparatus is grounded, and a complete Faraday cage is formed on a camera module, to assemble the camera module into a new shielding apparatus for shielding an electromagnetic signal, thereby achieving a relatively desirable shielding effect. In addition, because there is no need to provide a shielding case outside the entire camera module, a size of the shielding apparatus can effectively be reduced without affecting appearance of an original structure. In addition, compared with a prior-art solution in which a shielding case is formed after a camera module is assembled, the shielding apparatus in this application can be assembled in parts. To be specific, after the outer surface of the lens barrel of the camera module is covered with the conducting layer to form a part of the shielding structure, the assembly is performed by using the first conductive structure, so as to form the shielding apparatus including the camera module and the complete shielding structure. In this way, a processing period prolonged because of a process of finally forming a shielding case can be shortened. In addition, an additional processing error caused by the process of finally forming the shielding case can be reduced, so as to increase a product qualification rate of camera modules.

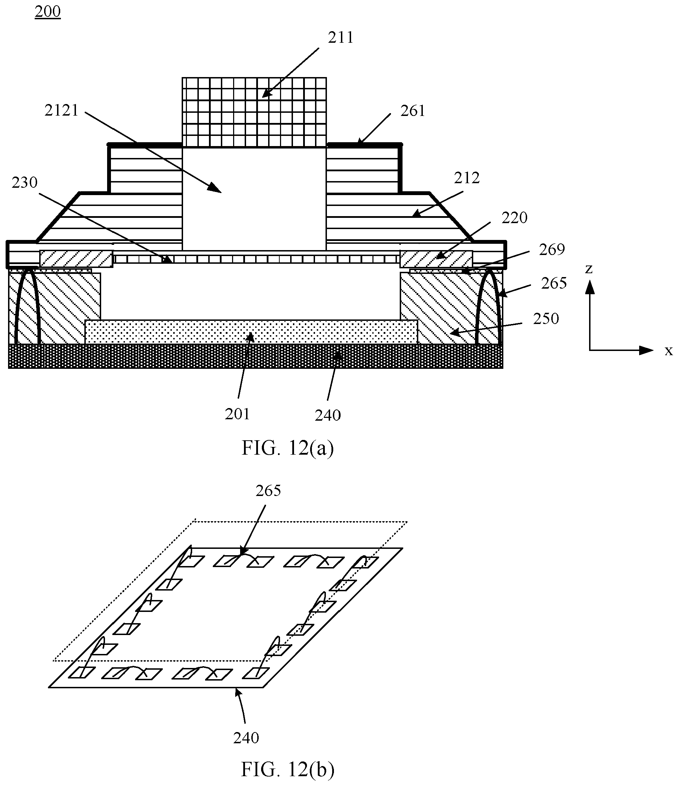

In all the foregoing embodiments described in FIG. 4(a) and FIG. 4(b) to FIG. 7, the first conductive structure needs to fill the support element. The first conductive structure may be filled only in the support element, or the first conductive structure may be filled in the support element and the plastic package assembly. With reference to FIG. 8 to FIG. 12(a) and FIG. 12(b), the following describes a shielding apparatus in which a conductive structure is filled in a plastic package assembly. In addition, for ease of differentiation, the conductive structure filled in the plastic package assembly is denoted as a second conductive structure.

FIG. 8 is another schematic structural diagram of a shielding apparatus according to this application. Referring to FIG. 8, the shielding apparatus includes a camera module and a shielding structure. The camera module includes a lens component, a support element 220, a plastic package assembly 250, a substrate 240, and a light filter 230 enclosed by the support element 220 that are successively disposed along a z direction from top to bottom, and the shielding structure includes a first conducting layer 261, a third conducting layer 262, and at least one second conductive structure 265.

For specific descriptions about a lens barrel assembly, the support element 220, the light filter 230, and the substrate 240, refer to the related descriptions of the embodiment corresponding to FIG. 4(a) and FIG. 4(b). Details are not described again. Elements such as a wire bond (wire bond) and a passive component are formed in the plastic package assembly 250 through plastic packaging, and the plastic package assembly 250 is fastened to the substrate 240 in a plastic package manner.

A lens barrel 212 may be made of a material having no conductive property, and an outer surface of the lens barrel 212 is covered with the first conducting layer 261. The support element 220 may also be made of a material having no conductive property, and an outer surface of the support element 220 is covered with the third conducting layer 262. For specific descriptions about the first conducting layer 261 and the third conducting layer 262, refer to the related descriptions of the embodiment corresponding to FIG. 2. Details are not described again. The lens barrel 212 and the support element 220 may be connected by using a conductive structure 266. For specific descriptions about a connection manner thereof, refer to the related descriptions of the embodiment corresponding to FIG. 2. Details are not described again. The second conductive structure 265 is filled in the plastic package assembly 250, or the second conductive structure 265 penetrating through the plastic package assembly 250 is formed in the plastic package assembly 250 through plastic packaging. A first end part of the second conductive structure 265 is connected to the third conducting layer 262, and a second end part of the second conductive structure 265 is connected to exposed metal of the substrate 240. The lens barrel 212, the support element 220, the plastic package assembly 250, and the substrate 240 are electrically connected by using the first conducting layer 261, the third conducting layer 262, and the second conductive structure 265. In this way, a relatively complete Faraday cage is formed on the camera module, thereby achieving a shielding effect.

In this embodiment, the second conductive structure 265 may be connected to both the support element 220 and the substrate 240 in various possible connection manners such as welding, bonding, and riveting.

For example, the second end part of the second conductive structure 265 may extend to a ground pad of the substrate 240, and is connected to the ground pad in a welding manner.

For example, the third conducting layer 262 may extend for a specific distance from the outer surface of the support element 220 to a bottom face that is of the support element 220 and that is opposite to the plastic package assembly 250, so that a part that is of the third conducting layer 262 and that covers the bottom face of the support element 220 is bonded to the first end part of the second conductive structure 265. In this way, the third conducting layer 262 is connected to the second conductive structure 265. To make the third conducting layer 262 better connected to the second conductive structure 265, optionally, the first end of the second conductive structure 265 may be connected to the third conducting layer 262 by using a conductive structure 268 formed by a conductive adhesive. To be specific, the conductive structure 268 is attached to the third conducting layer 262 and the lower surface of the support element 220.

For example, the second conductive structure 265 may be made of a material having a conductive property such as a conductive adhesive, metal, a metal compound, or a carbon-based compound. This is not limited in this application. For example, in FIG. 8, the second conductive structure 265 may be a metal dome made of metal. For another example, the second conductive structure 265 may alternatively be a structure formed by a conductive adhesive.

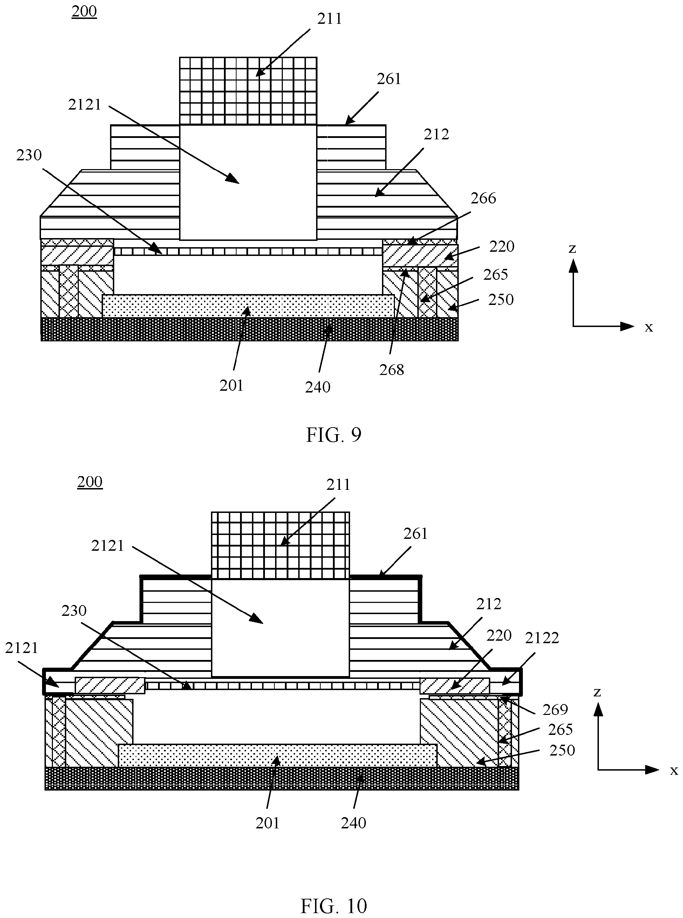

FIG. 9 is another schematic structural diagram of a shielding apparatus according to this application. A difference between a structure shown in FIG. 9 and the structure shown in FIG. 8 lies in: A lens barrel 212 and a support element 220 are made of a composite material having a conductive property, and a conductive material may be filled in plastics to form conductive plastics. Optionally, the conductive material filled in the lens barrel and the support element may be any one of stainless steel fiber, nickel fiber, carbon fiber, and carbon nanotubes. In this structure, the lens barrel 212 and the support element 220 can be used as a part of a shielding structure, the support element 220 and the lens barrel 212 may be connected by using a conductive structure 266, and the support element 220 and a second conductive structure 265 may be connected by using a conductive structure 268. In this way, the lens barrel, the support element, a plastic package assembly, and a substrate are electrically connected.

For example, the conductive structure 266 or the conductive structure 268 may be made of a material having a conductive property such as a conductive adhesive, metal, a metal compound, or a carbon-based compound, and two components may be connected by using a conductive structure in various possible connection manners such as welding, bonding, and riveting.

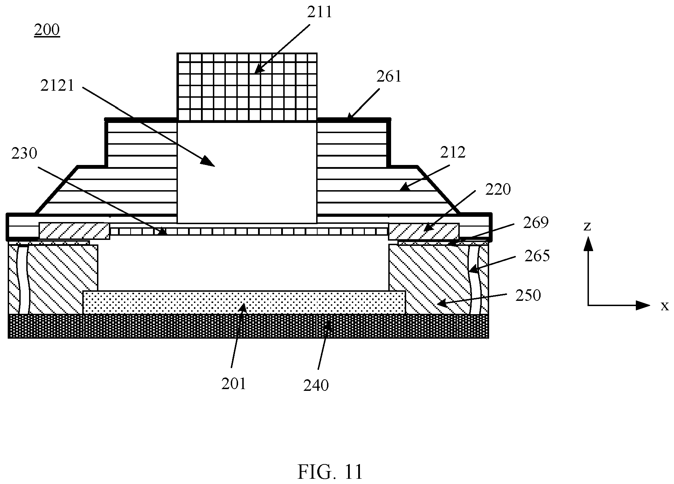

FIG. 10 is another schematic structural diagram of a shielding apparatus according to this application. Referring to FIG. 10, the shielding apparatus 200 includes a camera module and a shielding structure. The camera module includes a lens component, a support element, a light filter, a plastic package assembly, a substrate, and at least one second conductive structure. The shielding structure may include a first conducting layer 261 and a second conductive structure 265. A difference between structures shown in FIG. 10 and FIG. 11 and the structures shown in FIG. 8 and FIG. 9 lies in that a lens barrel 212 of the shielding apparatus 200 encloses the support element 220 and the light filter 230.

The lens component includes the lens barrel 212 and an optical lens assembly 211, the lens barrel 212 is of a cylindrical structure, the lens barrel 212 includes an optical channel 2121 penetrating through the lens barrel 212 and forms two ends provided with openings, and the optical lens assembly 211 is disposed at one end (denoted as a first end) that is of the lens barrel 212 and that is provided with an opening, to allow light to enter the optical channel 2121 through the optical lens assembly 211. A peripheral edge of a second end that is of the lens barrel 212 and that is provided with an opening forms a raised edge 2122 in a direction in which the lens barrel 212 is close to the plastic package assembly, to form, in a middle region of the second end of the lens barrel 212, a depressed region surrounded by the raised edge 2122. The support element 220 and the light filter 230 are accommodated in the depressed region to enclose the support element 220 and the light filter 230 by using the raised edge 2122, the support element 220 is of a cylindrical structure, the support element 220 encloses and is fixedly connected to the light filter 230, and the light filter 230 and the optical channel 2121 are disposed opposite to each other to allow light to enter the light filter 230 through the optical channel 2121. The plastic package assembly 250 is disposed between the lens barrel 212 and the substrate 240, elements such as a wire bond and a passive component are formed in the plastic package assembly 250 through plastic packaging, and the plastic package assembly 250 is fastened to the substrate 240 in a plastic packaging manner.

A component having a conductive property such as a ground pad is disposed on the substrate 240, and the substrate 240 is fixedly connected to elements such as a PCB, an FPC, various passive components (such as a capacitor, a resistor, and an inductor), and various chips 201 (such as a sensor chip).

The lens barrel 212 may be made of a material having no conductive property, and an outer surface of the lens barrel 212 is covered with the first conducting layer 261. Because the support element 220 is enclosed inside the raised edge 2122 of the lens barrel 212, a shielding effect can be achieved by using the first conducting layer 261 on the lens barrel 212, without processing the support element 220. The second conductive structure 265 is filled in the plastic package assembly 250, or the second conductive structure 265 penetrating through the plastic package assembly 250 is formed in the plastic package assembly 250 through plastic packaging. A first end part of the second conductive structure 265 is connected to the first conducting layer 261, and a second end part of the second conductive structure 265 is connected to exposed metal of the substrate. The lens barrel 212, the plastic package assembly 250, and the substrate 240 are electrically connected by using the first conducting layer 261 and the second conductive structure 265. In this way, a relatively complete Faraday cage is formed on the camera module, thereby achieving a shielding effect.

In this embodiment, the second conductive structure 265 may be connected to both the raised edge 2122 of the lens barrel 212 and the substrate 240 in various possible connection manners such as welding, bonding, and riveting.

For example, one end of the second conductive structure 265 may extend to the ground pad of the substrate 240, and is connected to the ground pad in a welding manner.

For example, the first conducting layer 261 may extend for a specific distance from the outer surface of the lens barrel 212 to a lower surface that is of the raised edge 2122 and that is opposite to the plastic package assembly 250, so that a part that is of the first conducting layer 261 and that covers the lower surface of the raised edge 2122 is bonded to the second conductive structure 265. In this way, the first conducting layer 261 is connected to the second conductive structure 265 through bonding. To make the first conducting layer 261 better connected to the second conductive structure 265, optionally, the first end part of the second conductive structure 265 may be attached to the first conducting layer 261 and the lower surface of the raised edge 2122 of the lens barrel 212 by using a conductive structure 269 formed by a conductive adhesive.

For example, the second conductive structure 265 may be made of a material having a conductive property such as a conductive adhesive, metal, a metal compound, or a carbon-based compound. This is not limited in this application. For example, in FIG. 10, the second conductive structure 265 may be a structure formed by a conductive adhesive.

Referring to FIG. 11, a difference between FIG. 11 and FIG. 10 lies in: In FIG. 11, the second conductive structure 265 may be a metal dome made of metal.

Referring to FIG. 12(a) and FIG. 12(b), a difference between FIG. 12(a) and FIG. 12(b) and FIG. 10 lies in: In FIG. 12(a) and FIG. 12(b), the second conductive structure 265 may be a gold ground wire made of metal. For example, referring to FIG. 12(a) and FIG. 12(b), before the plastic package assembly is formed on the substrate 240, to avoid laser hole burning, the gold ground wire is disposed on the ground pad of the substrate 240 before the plastic package assembly is formed on the substrate 240. For example, referring to FIG. 12(b), the gold ground wire may be welded to two adjacent ground pads to form gold ground wires around the substrate 240. After the plastic package assembly is formed through plastic packaging, a layer of the plastic package assembly is removed in a manner such as laser or knife cutting to make the gold ground wires exposed, and one end of the gold ground wire is connected to the first conducting layer 261. Optionally, the gold ground wire may be attached to the first conducting layer 261 by using the conductive structure 269 formed by the conductive adhesive.

In the shielding apparatus, the lens barrel encloses and is fixedly connected to the support element, the lens barrel is covered with the first conducting layer, and the plastic package assembly is filled with the second conductive structure, so that the lens barrel and the plastic package assembly each have a shielding function. In addition, the lens barrel, the plastic package assembly, and the substrate are connected by using the second conductive structure, so that the lens barrel, the support element, the plastic package assembly, and the substrate are electrically connected by using the first conducting layer and the second conductive structure. In this way, the shielding apparatus is grounded, and a complete Faraday cage is formed on a camera module, to assemble the camera module into a new shielding apparatus for shielding an electromagnetic signal, thereby achieving a relatively desirable shielding effect.

In addition, in the shielding apparatus in this application, the lens barrel is covered with the first conducting layer, and the plastic package assembly is filled with the second conductive structure. In this way, a relatively large shielding case that can accommodate the camera module may not need to be provided outside the entire camera module. Therefore, a size of the shielding apparatus can effectively be reduced without affecting appearance of an original structure.

In addition, compared with a prior-art solution in which a shielding case is formed after a camera module is assembled, the shielding apparatus in this application can be assembled in parts. To be specific, the outer surface of the lens barrel of the camera module is covered with the first conducting layer, the plastic package assembly is filled with the second conductive structure, and the first conducting layer is connected to the second conductive structure for assembly to form the shielding apparatus including the camera module and the complete shielding structure. In this way, a processing period prolonged because of a process of finally forming a shielding case can be shortened. In addition, an additional processing error caused by the process of finally forming the shielding case can be reduced, so as to increase a product qualification rate of camera modules.

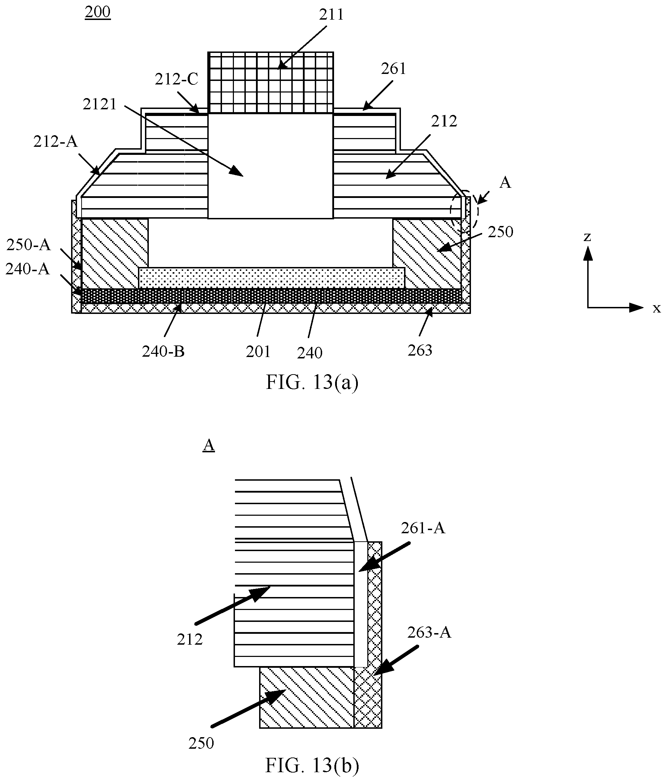

With reference to FIG. 13(a) and FIG. 13(b) to FIG. 16, the following describes another shielding apparatus provided in this application.

It should be understood that a circumferential direction of a lens barrel, a circumferential direction of a plastic package assembly 250, and a circumferential direction of a substrate 240 that are described below are all directions around a z direction, and the z direction is perpendicular to a surface of the substrate.

In structures in FIG. 13(a) and FIG. 13(b) to FIG. 16, a camera module may include two parts connected to each other, a first part includes the lens barrel, a second part includes at least the substrate, an outer surface of the first part is covered with a first conducting layer, an outer surface of the second part is covered with a second conducting layer, and the first conducting layer is connected to the second conducting layer to form a shielding structure wrapped outside the camera module.

FIG. 13(a) and FIG. 13(b) is another schematic structural diagram of a shielding apparatus according to this application. FIG. 13(a) is a sectional view of the shielding apparatus on an xz plane, and FIG. 13(b) is a schematic sectional view of a local region of the shielding apparatus.

Referring to FIG. 13(a) and FIG. 13(b), the shielding apparatus 200 includes a camera module and a shielding structure. The camera module includes a lens component, a plastic package assembly 250, and a substrate 240 that are successively disposed along a z direction from top to bottom, and the shielding structure includes a first conducting layer 261 and a second conducting layer 263.

The lens component includes an optical lens assembly 211 and a lens barrel 212, the lens barrel 212 is of a cylindrical structure, the lens barrel 212 includes an optical channel 2121 penetrating through the lens barrel 212 and forms two ends provided with openings, and the optical lens assembly 211 is disposed at a first end that is of the lens barrel 212 and that is provided with an opening, to allow light to enter the optical channel 2121 through the optical lens assembly 211. The plastic package assembly 250 formed on the substrate 240 through plastic packaging is fastened to the substrate 240, elements such a wire bond (wire bond) and a passive component are formed in the plastic package assembly 250 through plastic packaging, the plastic package assembly 250 and the lens barrel 212 may be connected through attachment by using glue, and various chips 201 (such as a sensor chip) may also be fastened to the substrate 240.

In this structure, the lens barrel 212 is used as a first part, the plastic package assembly 250 and the substrate 240 are used as a second part connected to the lens barrel 212, the first conducting layer 261 covers an outer surface of the lens barrel 212, the second conducting layer 263 covers an outer surface of the second part formed by the substrate 240 and the plastic package assembly 250, and the first conducting layer 261 is connected to the second conducting layer 263. In this way, the two conducting layers are electrically connected. The outer surface of the lens barrel 212 includes a side face 212-A in a circumferential direction of the lens barrel and a top face 212-C that is perpendicular to the z direction and that is away from the substrate 240. An outer surface of the plastic package assembly 250 includes a side face 250-A in a circumferential direction of the plastic package assembly. An outer surface of the substrate 240 includes a side face 240-A in a circumferential direction of the substrate 240 and a bottom face 240-B that is perpendicular to the z direction and that is away from the lens barrel 212, and there is exposed metal such as copper on the bottom face 240-B of the substrate 240. The second conducting layer 263 covers the bottom face 240-B of the substrate 240 and is connected to the metal, so that the shielding structure formed by the first conducting layer 261 and the second conducting layer 263 can be electrically connected to the substrate 240. In this way, the shielding apparatus is grounded, and a complete Faraday cage is formed outside the camera module, thereby achieving a shielding effect.

Referring to FIG. 13(b), the second conducting layer 263 extends towards a first end part 261 -A of the first conducting layer 261 to form a first end part 263-A of the second conducting layer 263, and the first end part 263-A of the second conducting layer 263 is bonded to the first end part 261-A of the first conducting layer 261, so that the two conducting layers are connected to each other. The first end part 261-A of the first conducting layer 261 is an end part close to the second conducting layer 263, and the first end part 263 -A of the second conducting layer 263 is an end part close to the first conducting layer 261. For example, the first end part 263-A of the second conducting layer 263 is set to be of a step-shaped structure, the first end part 261-A of the first conducting layer 261 is set to be of a structure in cooperation with the step-shaped structure, and the end parts of the two conducting layers are connected to each other through bonding. For example, the first end part 263-A of the step-shaped structure may be of a structure with an L-shaped cross section, and the first end part 263-A of the step-shaped structure accommodates and is fixedly connected to the first end part 261-A of the first conducting layer 261. For example, the first end part 263-A of the first conducting layer 263 may be connected to the first end part 261-A of the second conducting layer 261 through welding or riveting, by using a conductive adhesive, or the like.

By using this structure in which the first conducting layer is connected to the second conducting layer by using the step-shaped structure, a contact area between the first conducting layer and the second conducting layer can be increased. In this way, binding force between the first conducting layer and the second conducting layer is increased, and the connection is more firm.

For example, the first conducting layer 261 may be formed on the outer surface of the lens barrel 212 in any one of the following manners: spraying, sputtering, transfer printing, or laser direct structuring (laser direct structuring, LDS). For example, the first conducting layer 261 may be made of a material having a conductive property such as metal, a metal compound, or a carbon-based compound. Similarly, a forming manner and a material of the second conducting layer 263 are similar to those of the first conducting layer 261. Details are not described again.

During assembly, the lens barrel covered with the first conducting layer and the substrate to which the plastic package assembly is fastened are assembled, outer surfaces of components (the plastic package assembly and the substrate) in an assembled structure except the lens barrel are covered with the second conducting layer, and the second conducting layer is connected to the first conducting layer to form, outside the camera module, the shielding structure that is basically closely attached to the camera module. In this way, a shielding effect is achieved by using the shielding structure.

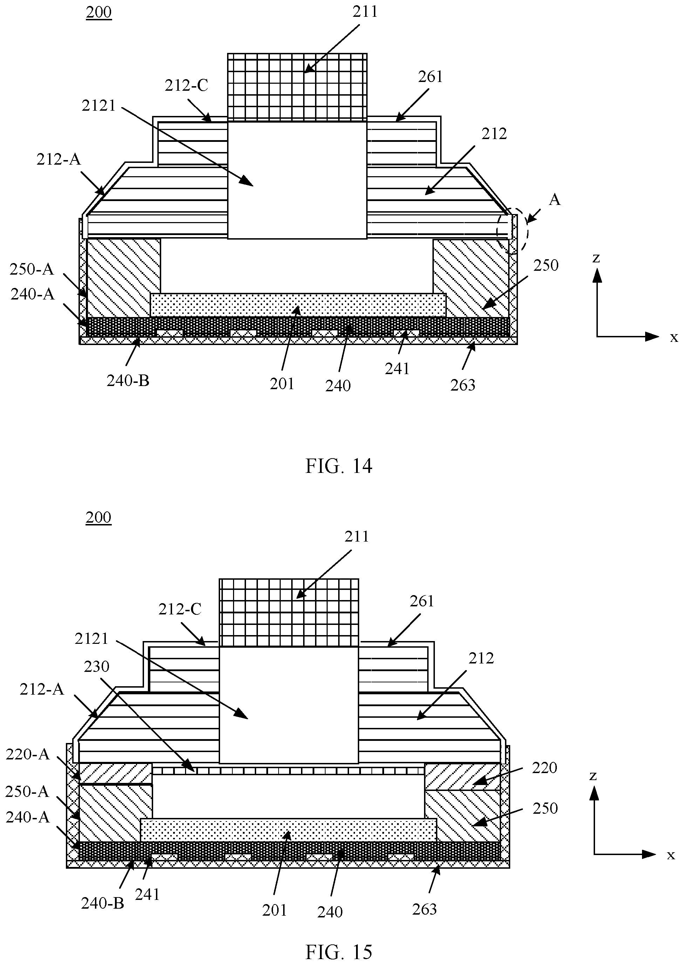

FIG. 14 is another schematic structural diagram of a shielding apparatus according to this application. A difference between FIG. 14 and FIG. 13(a) and FIG. 13(b) lies in: At least one groove 241 is disposed in a substrate 240 in FIG. 14, there is exposed metal such as copper in the groove 241, and a second conducting layer 263 extends to the groove 241 to fill the groove 241, to be connected to the metal. In this structure, a surface of the groove 241 is used as a part of a bottom face 240-B of the substrate 240, and the second conducting layer 263 covers the bottom face 240-B that is of the substrate 240 and that includes the surface of the groove 241. The second conducting layer 263 that is of a convex structure and that covers the bottom face 240-B of the substrate 240 is formed on the bottom face 240-B of the substrate 240, so that a shielding structure formed by a first conducting layer 261 and the second conducting layer 263 is electrically connected to the substrate 240. In this way, the shielding apparatus is grounded, and a complete Faraday cage is formed outside a camera module, thereby achieving a shielding effect.

FIG. 15 is another schematic structural diagram of a shielding apparatus according to this application. A difference between FIG. 15 and 14 lies in: A camera module in FIG. 14 further includes a support element 220 and a light filter 230 that are disposed between a plastic package assembly 250 and a lens barrel 212, the support element is of a cylindrical structure, and the support element 220 encloses and is connected to the light filter 230. In this structure, the lens barrel 212 is used as a first part, a first conducting layer 261 covers an outer surface of the lens barrel 212, the support element 220, the plastic package assembly 250, and a substrate 240 are used as a second part connected to the lens barrel 212, a second conducting layer 263 covers an outer surface of the second part formed by the support element 220, the plastic package assembly 250, and the substrate 240, and the first conducting layer 261 is connected to the second conducting layer 263. In this way, the two conducting layers are electrically connected. An outer surface of the support element 220 includes a side face 220-A in a circumferential direction of the support element 220. Specific descriptions about the outer surface of the lens barrel 212, an outer surface of the plastic package assembly 250, and an outer surface of the substrate 240 are the same as the related descriptions of the embodiments corresponding to FIG. 13(a) and FIG. 13(b) and FIG. 14. Details are not described again. In this way, a shielding structure formed by the first conducting layer 261 and the second conducting layer 263 is electrically connected to the substrate 240, so that the shielding apparatus is grounded, and a complete Faraday cage is formed outside the camera module, thereby achieving a shielding effect.

For specific descriptions about the connection between the first conducting layer 261 and the second conducting layer 263, and the case in which the first conducting layer 261 covers the outer surface of the lens barrel 261 and the second conducting layer 263 covers the outer surface of the second part, refer to the related descriptions in FIG. 13(a) and FIG. 13(b) and FIG. 14. Details are not described again.

It should be understood that the foregoing structure is merely used as an example for description. For example, in the camera module that is in the structure shown in FIG. 14 and that includes the support element, the camera module may alternatively be divided into three parts. The lens barrel is used as a first part, the substrate is used as a third part, and the support element is used as a second part. The outer surface of the lens barrel is covered with the first conducting layer, the outer surface of the support element is covered with a third conducting layer, and the outer surface of the substrate is covered with the second conducting layer. The first conducting layer and the third conducting layer may be connected by using a conductive adhesive or the like. A connection manner between the second conducting layer and the third conducting layer may be the same as that shown in FIG. 13(a) and FIG. 13(b).

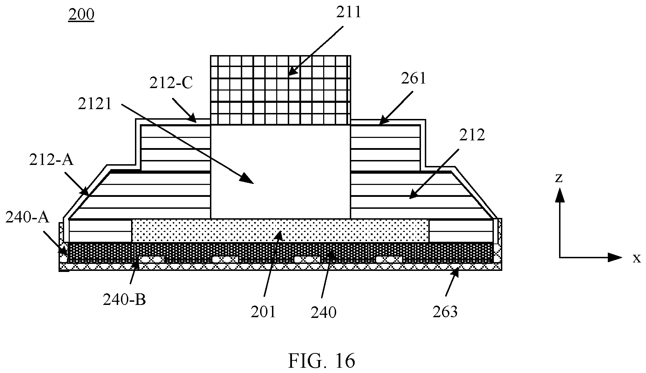

FIG. 16 is another schematic structural diagram of a shielding apparatus according to this application. A camera module of the shielding apparatus includes a lens component and a substrate. The lens component includes an optical lens assembly 211 and a lens barrel 212. Various chips 201 (such as a sensor chip), a passive component, and the like may be fastened to the substrate 240. A peripheral edge of a second end that is of the lens barrel 212 and that is provided with an opening forms a raised edge 2122 in a direction in which the lens barrel 212 is close to the substrate 240, to form, in a middle region of the second end of the lens barrel 212, a depressed region surrounded by the raised edge 2122. Various elements on the substrate 240 may be accommodated in the depressed region. The raised edge 2122 of the lens barrel 212 may be attached to the substrate 240 by using a sticky material such as glue. In this structure, the lens barrel 212 is used as a first part, the substrate 240 is used as a second part connected to the lens barrel, a first conducting layer 261 covers an outer surface of the lens barrel 212, and a second conducting layer 263 covers an outer surface of the substrate 240. In this way, the two conducting layers are electrically connected. Specific descriptions about the outer surface of the lens barrel 212 and the outer surface of the substrate 240 are the same as the related descriptions of the embodiments corresponding to FIG. 13(a) and FIG. 13(b) and FIG. 14. Details are not described again. In this way, a shielding structure formed by the first conducting layer 261 and the second conducting layer 263 is electrically connected to the substrate 240, so that the shielding apparatus is grounded, and a complete Faraday cage is formed outside the camera module, thereby achieving a shielding effect.

In the shielding apparatus, the camera module of the shielding apparatus includes two parts connected to each other, the first part includes the lens barrel, the second part includes at least the substrate, the outer surface of the first part is covered with the first conducting layer, the outer surface of the second part is covered with the second conducting layer, and the first conducting layer is connected to the second conducting layer to form the shielding structure wrapped outside the camera module. In this way, the shielding structure formed by the first conducting layer and the second conducting layer can be electrically connected to the substrate, so that the shielding apparatus is grounded, and a complete Faraday cage is formed outside the camera module, thereby achieving a shielding effect of shielding an electromagnetic signal

In addition, the first conducting layer is connected to the second conducting layer and is connected to the metal of the substrate, and a second conductor layer covers the outer surface of the substrate, so that a straight-line shaped metal structure of the substrate can be expanded to a metal structure of a U-shaped structure. In this way, a metal area of the substrate and a heat dissipation area are increased, thereby improving a heat dissipation effect of the entire shielding apparatus.

In addition, the second conducting layer is stably connected to the first conducting layer, so that the two conductive substances can directly be bonded without requiring other electrical connection measures. In this way, an excellent conductive property and low contact resistance are implemented.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A shielding apparatus, wherein the shielding apparatus comprises a lens component, a support element, and a substrate;
the lens component comprises a lens barrel and an optical lens assembly, the lens barrel is of a cylindrical structure, the lens barrel comprises an optical channel penetrating through the lens barrel and forms two ends provided with openings, the optical lens assembly is disposed at one end that is of the lens barrel and that is provided with an opening, to allow light to enter the optical channel through the optical lens assembly, and the lens barrel is made of a material having no conductive property and an outer surface of the lens barrel is covered with a first conducting layer; and
the support element is disposed between the lens barrel and the substrate, the support element is made of a material having no conductive property, the support element is filled with at least one first conductive structure, a first end part of the first conductive structure is connected to the first conducting layer, and a second end part of the first conductive structure is connected to exposed metal of the substrate.

2. The shielding apparatus according to claim 1, wherein at least one first through hole penetrating through the support element is disposed in the support element, and the first through hole is filled with the first conductive structure.

3. The shielding apparatus according to claim 2, wherein the first through hole is an open hole disposed at an edge of the support element.

4. The shielding apparatus according to any one of claims 1 to 3, wherein a first through hole penetrating through the support element is disposed inside the support element, and each end part of the first conductive structure is formed by a plurality of convex structures.

5. The shielding apparatus according to any one of claims 1 to 4, wherein the shielding apparatus further comprises a plastic package assembly disposed between the support element and the substrate, and the first conductive structure penetrates through the plastic package assembly.

6. The shielding apparatus according to any one of claims 1 to 5, wherein the first end part of the first conductive structure is connected to the first conducting layer by using a conductive adhesive.

7. The shielding apparatus according to any one of claims 1 to 5, wherein the second end part of the first conductive structure is connected to a ground pad of the substrate.

8. The shielding apparatus according to any one of claims 1 to 7, wherein the first conductive structure is a structure formed by a conductive adhesive, or a metal dome.

9. A shielding apparatus, wherein the shielding apparatus comprises a lens component, a support element, a plastic package assembly, and a substrate;
the lens component comprises a lens barrel and an optical lens assembly, the lens barrel is of a cylindrical structure, the lens barrel comprises an optical channel penetrating through the lens barrel and forms two ends provided with openings, the optical lens assembly is disposed at one end that is of the lens barrel and that is provided with an opening, to allow light to enter the optical channel through the optical lens assembly, and the lens barrel is made of a material having no conductive property and an outer surface of the lens barrel is covered with a first conducting layer;
the support element is disposed between the lens barrel and the plastic package assembly, the support element is made of a material having no conductive property and an outer surface of the support element is covered with a third conducting layer, and the first conducting layer is connected to the third conducting layer; and
the plastic package assembly is disposed between the support element and the substrate, at least one second conductive structure penetrating through the plastic package assembly is formed in the plastic package assembly through plastic packaging, a first end part of the second conductive structure is connected to the third conducting layer, and a second end part of the second conductive structure is connected to exposed metal of the substrate.

10. The shielding apparatus according to claim 9, wherein the first end part of the second conductive structure is connected to the third conducting layer by using a conductive adhesive.

11. The shielding apparatus according to claim 9 or 10, wherein the second end part of the second conductive structure is connected to a ground pad of the substrate.

12. The shielding apparatus according to any one of claims 9 to 11, wherein the second conductive structure is any one of the following: a structure formed by a conductive adhesive, a metal dome, or a gold ground wire disposed on the ground pad of the substrate.

13. A shielding apparatus, wherein the shielding apparatus comprises a lens component, a support element, a plastic package assembly, and a substrate;
the lens component comprises a lens barrel and an optical lens assembly, the lens barrel is of a cylindrical structure, the lens barrel comprises an optical channel penetrating through the lens barrel and forms two ends provided with openings, the optical lens assembly is disposed at a first end that is of the lens barrel and that is provided with an opening, to allow light to enter the optical channel through the optical lens assembly, a peripheral edge of a second end that is of the lens barrel and that is provided with an opening forms a raised edge in a direction in which the lens barrel is close to the plastic package assembly, to form, in a middle region of the second end of the lens barrel, a depressed region surrounded by the raised edge, and the lens barrel is made of a material having no conductive property and an outer surface of the lens barrel is covered with a first conducting layer;
the support element is accommodated in the depressed region to enclose the support element by using the raised edge; and
the plastic package assembly is disposed between the lens barrel and the substrate, at least one second conductive structure penetrating through the plastic package assembly is formed in the plastic package assembly through plastic packaging, a first end part of the second conductive structure is connected to the first conducting layer, and a second end part of the second conductive structure is connected to exposed metal of the substrate.

14. The shielding apparatus according to claim 13, wherein the first end part of the second conductive structure is connected to the first conducting layer by using a conductive adhesive.

15. The shielding apparatus according to claim 13 or 14, wherein the second end part of the second conductive structure is connected to a ground pad of the substrate.

16. The shielding apparatus according to any one of claims 13 to 15, wherein the second conductive structure is any one of the following: a structure formed by a conductive adhesive, a metal dome, or a gold ground wire disposed on the ground pad of the substrate.

17. A shielding apparatus, wherein the shielding apparatus comprises a lens component and a substrate;
the lens component is disposed on one side of the substrate and comprises a lens barrel and an optical lens assembly, the lens barrel is connected to the substrate, the lens barrel is of a cylindrical structure, the lens barrel comprises an optical channel penetrating through the lens barrel and forms two ends provided with openings, the optical lens assembly is disposed at one end that is of the lens barrel and that is provided with an opening, to allow light to enter the optical channel through the optical lens assembly, the lens barrel is made of a material having no conductive property and an outer surface of the lens barrel is covered with a first conducting layer, the outer surface of the lens barrel comprises a side face in a circumferential direction of the lens barrel and a top face that is perpendicular to a first direction and that is away from the substrate, the circumferential direction of the lens barrel is around the first direction, and the first direction is perpendicular to the substrate; and
an outer surface of the substrate is covered with a second conducting layer, the second conducting layer is connected to the first conducting layer, the outer surface of the substrate comprises a side face in a circumferential direction of the substrate and a bottom face that is perpendicular to the first direction and that is away from the lens barrel assembly, there is exposed metal on the bottom face of the substrate, and the circumferential direction of the substrate is around the first direction.

18. The shielding apparatus according to claim 17, wherein a first end part that is of the second conducting layer and that is close to the first conducting layer is set to be of a step-shaped structure, a first end part that is of the first conducting layer and that is close to the second conducting layer is set to be of a structure in cooperation with the step-shaped structure, and the first end part of the first conducting layer is connected to the first end part of the second conducting layer.

19. The shielding apparatus according to claim 18, wherein the first end part of the second conducting layer is set to be of a step-shaped structure with an L-shaped cross section, and the first end part of the first conducting layer is connected to and accommodated in the first end part of the second conducting layer.

20. The shielding apparatus according to any one of claims 17 to 19, wherein at least one groove is disposed in the bottom face of the substrate, and the second conducting layer extends to the groove to fill the groove.

21. The shielding apparatus according to any one of claims 17 to 20, wherein the shielding apparatus further comprises a support element disposed between the substrate and the lens barrel, the second conducting layer further covers a side face that is of the support element and that is in a circumferential direction of the support element, and the circumferential direction of the support element is around the first direction.

22. The shielding apparatus according to any one of claims 17 to 21, wherein the shielding apparatus further comprises a plastic package assembly disposed between the substrate and the lens barrel, the second conducting layer further covers a side face that is of the plastic package assembly and that is in a circumferential direction of the plastic package assembly, and the circumferential direction of the plastic package assembly is around the first direction.

23. An electronic device, comprising an antenna and the shielding apparatus according to any one of claims 1 to 8.

24. An electronic device, comprising an antenna and the shielding apparatus according to any one of claims 9 to 12.

25. An electronic device, comprising an antenna and the shielding apparatus according to any one of claims 13 to 16.

26. An electronic device, comprising an antenna and the shielding apparatus according to any one of claims 17 to 22.
